(19) Europäisches Patentamt / European Patent Office / Office européen des brevets

(11) **EP 4 505 760 B1**

(12) **EUROPÄISCHE PATENTSCHRIFT**

(45) Veröffentlichungstag und Bekanntmachung des Hinweises auf die Patenterteilung:
**03.12.2025 Patentblatt 2025/49**

(21) Anmeldenummer: **24728208.0**

(22) Anmeldetag: **22.05.2024**

(51) Internationale Patentklassifikation (IPC):
**H03G 3/32** *(2006.01)* **H04R 25/00** *(2006.01)*
**G10L 21/0364** *(2013.01)*

(52) Gemeinsame Patentklassifikation (CPC):
**H04R 25/356; G10L 21/0364; H03G 3/32;**
H04R 2225/41; H04R 2225/43

(86) Internationale Anmeldenummer:
**PCT/EP2024/064022**

(87) Internationale Veröffentlichungsnummer:
**WO 2024/240790 (28.11.2024 Gazette 2024/48)**

(54) **HÖRGERÄT UND VERFAHREN ZUM BETRIEB EINES HÖRGERÄTS**

HEARING AID AND METHOD FOR OPERATING A HEARING AID

PROTHÈSE AUDITIVE ET PROCÉDÉ DE FONCTIONNEMENT D'UNE PROTHÈSE AUDITIVE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **23.05.2023 DE 102023204769**

(43) Veröffentlichungstag der Anmeldung:
**12.02.2025 Patentblatt 2025/07**

(73) Patentinhaber: **Sivantos Pte. Ltd.**
**Singapore 539775 (SG)**

(72) Erfinder:
• **FÖLLMER, Jurek**
  **91058 Erlangen (DE)**
• **WILSON, Cecil**
  **91058 Erlangen (DE)**
• **BEST, Sebastian**
  **91058 Erlangen (DE)**

(74) Vertreter: **FDST Patentanwälte**
**Nordostpark 16**
**90411 Nürnberg (DE)**

(56) Entgegenhaltungen:
WO-A1-2021/089108       WO-A1-2022/128082
DE-A1- 102005 061 000     DE-A1- 102018 207 343
DE-B4- 102007 035 174     US-B2- 7 773 763

• DILLON HARVEY: "Hearing Aids Second Edition", BOOK, 10 December 2012 (2012-12-10), XP093237924

**Beschreibung**

Die Erfindung betrifft ein Hörgerät sowie ein Verfahren zum Betrieb eines solchen.

Ein Hörgerät weist allgemein einen Eingangswandler, eine Signalverarbeitung und einen Ausgangswandler auf. Der Eingangswandler ist üblicherweise ein Mikrofon. Der Ausgangswandler ist üblicherweise ein Hörer, welcher auch als Lautsprecher oder Receiver bezeichnet wird. Ein Hörgerät ist regelmäßig einem einzelnen Nutzer zugeordnet und wird lediglich von diesem verwendet. Ein Hörgerät dient beispielsweise zur Versorgung eines hörgeschädigten Nutzers und zum Ausgleich eines Hörverlusts dieses Nutzers. Der Eingangswandler erzeugt ein Eingangssignal, welches der Signalverarbeitung zugeführt wird. Die Signalverarbeitung modifiziert das Eingangssignal und erzeugt dadurch ein Ausgangssignal, welches somit ein modifiziertes Eingangssignal ist. Zum Ausgleich eines Hörverlusts wird das Eingangssignal beispielsweise gemäß einem Audiogramm (Hörbereich) des Nutzers mit einem frequenzabhängigen Verstärkungsfaktor verstärkt. Das Ausgangssignal wird schließlich mittels des Ausgangswandlers an den Nutzer ausgegeben. Bei einem Hörgerät mit Mikrofon und Hörer erzeugt das Mikrofon entsprechend aus Schallsignalen in der Umgebung das Eingangssignal und der Hörer aus dem Ausgangssignal wieder ein Schallsignal. Bei dem Eingangssignal und dem Ausgangssignal handelt es sich um elektrische Signale, welche daher auch kurz jeweils als Signal bezeichnet werden. Die Schallsignale der Umgebung und das gegebenenfalls vom Hörer ausgegebene Schallsignal sind demgegenüber akustische Signale.

Abseits davon ist es vorteilhaft, in ein Hörgerät eine automatische Verstärkungsregelung, kurz AGC (automatic gain control) zu integrieren. Hierzu weist das Hörgerät zweckmäßigerweise eine entsprechende AGC-Einheit auf, mit welcher sich die Dynamik des Eingangssignals modifizieren lässt, um eine bestimmte Dynamik für das Ausgangssignal zu erhalten. Dabei wird ein Pegel des Eingangssignals gemäß einer AGC-Funktion auf einen Pegel für das Ausgangssignal verstärkt. Die AGC-Funktion enthält beispielsweise einen Kniepunkt, unterhalb welchem das Ausgangssignal dem Eingangssignal entspricht (Verstärkung = 1) und oberhalb welchem eine Kompression erfolgt (Verstärkung < 1). Die AGC-Funktion wird auch als Dynamikkurve (dynamic curve) bezeichnet.

Nachteilig an einer AGC ist, dass die Kompression in manchen Situationen zu einer Verringerung des SNR (signal to noise ratio) des Eingangssignals führen kann. Speziell im Fall von einem Eingangssignal, welches Sprache enthält, verringert sich dadurch die Sprachverständlichkeit. Dies ist besonders problematisch in einer lauten Umgebung, welche an sich bereits ein niedriges SNR aufweist.

Es wird verwiesen auf DE 10 2005 061000 A1, WO 2021/089108 A1, WO 2022/128082 A1, DE 10 2007 035174 B4, DE 10 2018 207343 A1, US 7 773 763 B2 und Dillon Harvey: "Hearing Aids Second Edition".

Vor diesem Hintergrund ist es eine Aufgabe der Erfindung, den Betrieb eines Hörgeräts mit einer AGC-Einheit zu verbessern. Hierzu sollen ein entsprechend verbessertes Verfahren und ein entsprechend verbessertes Hörgerät angegeben werden.

Die Aufgabe wird erfindungsgemäß gelöst durch ein Verfahren mit den Merkmalen gemäß Anspruch 1 sowie durch ein Hörgerät mit den Merkmalen gemäß Anspruch 14. Vorteilhafte Ausgestaltungen, Weiterbildungen und Varianten sind Gegenstand der Unteransprüche. Die Ausführungen im Zusammenhang mit dem Verfahren gelten sinngemäß auch für das Hörgerät und umgekehrt. Sofern nachfolgend implizit oder explizit Schritte des Verfahrens beschrieben werden, ergeben sich vorteilhafte Ausgestaltungen für das Hörgerät dadurch, dass dieses eine Signalverarbeitung aufweist, welche ausgebildet ist, einen oder mehrere dieser Schritte auszuführen.

Ein Kerngedanke der Erfindung ist insbesondere, eine AGC-Funktion, gemäß welcher eine AGC-Einheit eines Hörgeräts eine AGC umsetzt, für verschiedene akustische Szenen jeweils optimal zu bestimmen und dabei auch einen individuellen Hörbereich eines Nutzers des Hörgeräts zu berücksichtigen. Im Betrieb des Hörgeräts wird damit die AGC-Funktion bei wechselnder Szene vorteilhafterweise automatisch angepasst und der Hörbereich des Nutzers wird möglichst optimal genutzt.

Das erfindungsgemäße Verfahren dient zum Betrieb eines Hörgeräts. Das Hörgerät ist einem Nutzer zugeordnet. Insbesondere ist das Hörgerät lediglich einem einzelnen Nutzer zugeordnet und wird lediglich von diesem verwendet. Bevorzugterweise dient das Hörgerät zur Versorgung eines hörgeschädigten Nutzers und zum Ausgleich eines Hörverlusts dieses Nutzers, wovon nachfolgend ohne Beschränkung der Allgemeinheit auch ausgegangen wird. Im Betrieb trägt und verwendet der Nutzer das Hörgerät, beispielsweise am Kopf und im oder am Ohr.

Das Hörgerät weist allgemein einen Eingangswandler, einen Ausgangswandler und eine Signalverarbeitung auf (auch als Signalverarbeitungseinheit bezeichnet). In einer zweckmäßigen Ausgestaltung ist der Eingangswandler ein Mikrofon und der Ausgangswandler ist ein Hörer. Von einer solchen Ausgestaltung wird nachfolgend ohne Beschränkung der Allgemeinheit ausgegangen. Im Betrieb erzeugt der Eingangswandler ein Eingangssignal, welches der Signalverarbeitung zugeführt wird. Ebenfalls im Betrieb modifiziert die Signalverarbeitung das Eingangssignal und erzeugt dadurch schließlich ein Ausgangssignal. Zur Modifikation des Eingangssignals weist die Signalverarbeitung eine oder mehrere Einheiten auf, welche je nach Bedarf hintereinander und/oder parallel zueinander geschaltet sind. Zum Ausgleich eines Hörverlusts wird das Eingangssignal oder ein davon abgeleitetes Signal beispielsweise gemäß einem Audiogramm (Hörbereich) des Nutzers mit einem frequenzabhängigen Verstärkungsfaktor verstärkt. Hierzu weist die Signalverarbeitung geeigneterweise eine entsprechende Verstärkungseinheit auf. Das Ausgangssignal wird schließlich im Betrieb mittels des Ausgangswandlers an den Nutzer ausgegeben. Bei einem Hörgerät mit Mikrofon und Hörer erzeugt das Mikrofon entsprechend aus Schallsignalen in der Umgebung das Eingangssignal und der Hörer aus dem Ausgangssignal wieder ein Schallsignal. Bei dem Eingangssignal und dem Ausgangssignal handelt es sich um elektrische Signale, welche daher auch kurz jeweils als Signal bezeichnet werden. Die Schallsignale der Umgebung und das gegebenenfalls vom Hörer ausgegebene Schallsignal sind demgegenüber akustische Signale. Alternativ oder zusätzlich zu Schallsignalen empfängt das Hörgerät Datensignale, z.B. einen Audiostream. Jegliche Signale (Schallsignale, Datensignale), welche das Hörgerät zur Modifizierung und Ausgabe an den Nutzer empfängt, werden zusammenfassend als Audiosignale bezeichnet.

Bei dem hier beschriebenen Verfahren nimmt das Hörgerät ein Audiosignal auf, insbesondere mit dem Eingangswandler, und erzeugt daraus ein Eingangssignal, ebenfalls mit dem Eingangswandler. Aus dem Eingangssignal wird ein AGC-Eingangssignal erzeugt, welches einer AGC-Einheit des Hörgeräts zugeführt wird. **In** der einfachsten Ausgestaltung ist das AGC-Eingangssignal identisch zum Eingangssignal, d.h. dieses wird einfach direkt an die AGC-Einheit weitergeleitet. Von einer solchen Ausgestaltung wird nachfolgend ohne Beschränkung der Allgemeinheit ausgegangen. Alternativ wird lediglich ein Teil des Eingangssignals als AGC-Eingangssignal verwendet oder das Eingangssignal wird zuvor noch durch eine andere Einheit der Signalverarbeitung modifiziert und dann als AGC-Eingangssignal verwendet. Die AGC-Einheit ist insbesondere ein Teil der Signalverarbeitung und beispielsweise vor, nach oder parallel zu der Verstärkungseinheit angeordnet.

Die AGC-Einheit verstärkt das AGC-Eingangssignal abhängig von einem Pegel des AGC-Eingangssignals und gemäß einer AGC-Funktion und gibt dann das entsprechend verstärkte AGC-Eingangssignal als ein AGC-Ausgangssignal aus.

Hierzu ordnet die AGC-Funktion jedem Pegelwert des AGC-Eingangssignals einen Pegelwert des AGC-Ausgangssignals zu. Das Verhältnis der beiden Pegelwerte an einem Punkt der AGC-Funktion ergibt eine Verstärkung (d.h. einen Verstärkungsfaktor), welche mit der AGC-Einheit für einen entsprechenden Pegelwert des AGC-Eingangssignals angewendet wird, um dieses zu verstärken. Die Verstärkung kann grundsätzlich kleiner, größer oder gleich 1 sein, d.h. gegebenenfalls erfolgt eine Abschwächung (< 1), eine bloße Durchleitung (= 1) oder eine echte Verstärkung im engeren Sinne (> 1). Anstelle der Pegel von AGC-Eingangssignal und AGC-Ausgangssignal verknüpft die AGC-Funktion in einer äquivalenten Ausgestaltung die Pegel von Eingangssignal und Ausgangssignal. Kurz gesagt: das AGC-Eingangssignal (und allgemein das Eingangssignal) weist eine Eingangsdynamik auf und das AGC-Ausgangssignal (und allgemein das Ausgangssignal) weist eine Ausgangsdynamik auf und die AGC-Funktion bildet die Eingangsdynamik auf die Ausgangsdynamik ab. Die Eingangsdynamik und die Ausgangsdynamik werden allgemein auch jeweils als "Dynamik" oder "Dynamikbereich" bezeichnet.

Die AGC-Funktion ist durch einen oder mehrere Parameter definiert. Vorliegend wird ohne Beschränkung der Allgemeinheit von mehreren Parametern ausgegangen. Die Parameter definieren die Form oder den Verlauf der AGC-Funktion und werden auch als AGC-Parameter bezeichnet. Diese Parameter sind vorteilhafterweise einstellbar, um die AGC-Funktion und damit die Modifizierung des AGC-Eingangssignals durch die AGC-Einheit zu verändern. Vorliegend werden die Parameter abhängig von einer akustischen Szene eingestellt, welche aktuell vorliegt, d.h. abhängig von einer aktuellen akustischen Szene. Genauer gesagt: abhängig von der aktuellen akustischen Szene werden entsprechend geeignete Werte für die Parameter ausgewählt. Die AGC-Funktion wird somit abhängig von der aktuellen akustischen Szene jeweils optimal parametriert. Als akustische Szene (kurz lediglich "Szene") wird allgemein eine akustische Umgebung verstanden, in welcher sich der Nutzer befindet. Die aktuelle akustische Szene ist dann diejenige akustische Umgebung, in welcher sich der Nutzer und somit auch das Hörgerät zum aktuellen Zeitpunkt tatsächlich befinden.

Die akustische Umgebung und damit auch die Szene ist insbesondere definiert durch jegliche Schallsignale, sowohl Nutzgeräusche als auch Störgeräusche, welche gegebenenfalls in unterschiedlicher Intensität und/oder aus unterschiedlichen Richtungen zum Nutzer und zum Hörgerät gelangen, sowie auch durch jegliche akustischen Eigenschaften der Umgebung, wie beispielsweise Nachhallzeit, Anzahl an Sprechern, SNR (signal to noise ratio) usw. Beispiele für Szenen sind "Gespräch", "Musik", "Gespräch mit Hintergrundgeräusch", "Störgeräusche". Andere Beispiele für Szenen sind Situationen mit einem bestimmten Geräuschpegel, einem bestimmten SNR oder einem bestimmten Dynamikbereich, insbesondere wie weiter unten noch erläutert.

Die akustische Szene, welche aktuell vorliegt, wird zweckmäßigerweise mittels einer Szenenerkennungseinheit des Hörgeräts bestimmt. Die Szenenerkennungseinheit ist insbesondere ein Teil der Signalverarbeitung. Zweckmäßigerweise wird das Eingangssignal oder ein davon abgeleitetes Signal der Szenenerkennungseinheit zugeführt, welche dann anhand davon die Szene bestimmt. Hierfür enthält die Szenenerkennungseinheit beispielsweise einen Klassifikator. Die AGC-Einheit ist insbesondere mit der Szenenerkennungseinheit verbunden und wird von dieser gesteuert, d.h. es erfolgt eine insbesondere automatische Einstellung der Parameter abhängig von der Bestimmung der aktuellen akustischen Szene. Die Szenenerkennungseinheit gibt insbesondere ein Steuersignal aus, welches von der jeweiligen Szene abhängig ist und von der AGC-Einheit empfangen wird, um dann die Parameter szenenabhängig einzustellen. Vorzugsweise entspricht eine Einstellgeschwindigkeit für die Parameter einer Geschwindigkeit der Bestimmung der Szene. Optional wird die Einstellung der Parameter geglättet, um das Ansprechen auf einen Wechsel der Szene zu optimieren, z.B. zu verringern. Beispielsweise wird hierzu das Steuersignal geglättet.

Schließlich erzeugt das Hörgerät aus dem AGC-Ausgangssignal ein Ausgangssignal (wie oben bereits beschrieben), zur Ausgabe an den Nutzer. Die obigen Ausführungen zum Eingangssignal gelten entsprechend, d.h. in der einfachsten Ausgestaltung ist das Ausgangssignal identisch zum AGC-Ausgangssignal, d.h. dieses wird einfach direkt z.B. an den Hörer weitergeleitet. Alternativ wird lediglich ein Teil des AGC-Ausgangssignals als Ausgangssignal verwendet oder das AGC-Ausgangssignal wird zuvor noch durch eine andere Einheit der Signalverarbeitung modifiziert, z.B. die Verstärkungseinheit, und dann als Ausgangssignal verwendet.

Nachfolgend wird ohne Beschränkung der Allgemeinheit davon ausgegangen, dass das AGC-Eingangssignal dem Eingangssignal entspricht und das AGC-Ausgangssignal dem Ausgangssignal. Unabhängig davon gelten sämtliche Ausführungen zum Eingangssignal und zum Ausgangssignal sinngemäß auch für das AGC-Eingangssignal beziehungsweise das AGC-Ausgangssignal und umgekehrt.

Ein wichtiger Vorteil der Erfindung ist insbesondere, dass eine genauere Steuerung der Ausgangsdynamik für verschiedene Szenen erfolgt. Grundsätzlich ist denkbar, dass eine AGC-Einheit eine fest vorgegebene AGC-Funktion in Kombination mit einstellbaren Zeitkonstanten nutzt oder für bestimmte, vordefinierte Szenen für das Eingangssignal einen Schwellwert, oberhalb von welchem eine Kompression erfolgt, anpasst. Die hier beschriebene Erfindung geht jedoch weiter und behandelt unterschiedliche Szenen mit einer je nach Szene gegebenenfalls unterschiedlich parametrierten AGC-Funktion, indem die Parameter szenenabhängig geeignet eingestellt werden, sodass sich für jede Szene eine entsprechend optimierte AGC-Funktion ergibt. Dadurch werden Hörkomfort und Sprachverständlichkeit für den Nutzer verbessert.

Ein weiterer Vorteil ist insbesondere, dass innerhalb derselben Szene die AGC mittels der AGC-Einheit stabiler ist, wobei unter "stabil" verstanden wird, dass die AGC-Funktion bei gegebener Szenendynamik innerhalb dieser Dynamik lediglich linear ist. Grundsätzlich ist es möglich, eine AGC-Funktion vorzugeben, welche innerhalb eines bestimmten Wertebereichs mit fester Größe stabil ist. Geht die Szenendynamik über diesen Wertebereich hinaus, wird dieser einfach verschoben, um die Dynamik aufzufangen. Ist die Dynamik dann größer als der Wertebereich führt dies aber nachteilig zu einem wiederholten Hin- und Herschieben des Wertebereichs. Auch eine Anpassung der Zeitkonstanten der AGC-Einheit kann zu einem unkontrollierbaren und/oder instabilen Verhalten führen. Die hier beschriebene Erfindung ändert dagegen die AGC-Funktion und damit das Verhalten der AGC-Einheit insbesondere lediglich dann, wenn sich auch die Szene ändert, wenn also mit der Szenenerkennungseinheit eine Änderung der aktuellen akustischen Szene erkannt wird. Innerhalb derselben Szene wird hingegen durchgängig dieselbe AGC-Funktion verwendet, diese ist jedoch durch die szenenabhängige Einstellung der Parameter auf die Szene optimiert.

Ein weiterer Vorteil ist insbesondere, dass ein SNR der Szene wenigstens beibehalten oder sogar vergrößert wird. Dadurch wird insbesondere die Sprachverständlichkeit verbessert. Grundsätzlich führt eine Kompression mittels der AGC-Einheit (d.h. Steigung der Dynamikkurve < 1) zu einer Verringerung des SNR. Dies ist besonders in lauten Szenen mit geringem SNR problematisch und kann die Sprachverständlichkeit verschlechtern. Erfindungsgemäß wird vorliegend durch die Einstellung der Parameter abhängig von der aktuellen akustischen Szene die AGC-Funktion an die Szene angepasst. Dies führt gegebenenfalls sogar zu einer Expansion (Steigung der Dynamikkurve > 1), in welchem Fall dann das SNR der aktuellen akustischen Szene entsprechend vergrößert wird, während aber die Dynamik des Ausgangssignals weiterhin optimal auf den Nutzer angepasst ist, z.B. auf dessen Hörbereich.

Die Begriffe "Dynamik" und "Dynamikbereich" werden vorliegend synonym verwendet und meinen ein Maß für einen Wertebereich, welcher durch einen veränderlichen Pegel eines Signals (z.B. Eingangssignal, Ausgangssignal, AGC-Eingangssignal, AGC-Ausgangssignal) abgedeckt wird. Die Dynamik ist insbesondere für ein vorgegebenes Zeitintervall definiert, z.B. ein Zeitintervall von 1 s. Mit dem Begriff "unteres Ende" ist dann ein Minimum des Dynamikbereichs gemeint, mit dem Begriff "oberes Ende" analog ein Maximum. Die Eingangsdynamik ist entsprechend charakterisiert durch Minimum und Maximum des AGC-Eingangssignals oder allgemein des Eingangssignals, die Ausgangsdynamik ist analog charakterisiert durch Minimum und Maximum des AGC-Ausgangssignals oder allgemein des Ausgangssignals. Während die Eingangsdynamik durch die aktuelle Szene vorgegeben ist, ist die Ausgangsdynamik mittels der AGC-Funktion grundsätzlich anpassbar, was vorliegend auch genutzt wird. Zudem ist es vorteilhaft möglich, ein besonders geeignetes Minimum oder Maximum oder beides für die Ausgangsdynamik vorzugeben, nämlich durch entsprechende Parametrierung der AGC-Funktion. Dies wird in einer bevorzugten Ausgestaltung genutzt, um einen Kammfiltereffekt zu reduzieren oder zu vermeiden, wie weiter unten noch näher erläutert wird.

In einer besonders einfachen Ausgestaltung entsprechen das untere und das obere Ende des Dynamikbereichs einem Minimum beziehungsweise einem Maximum des Pegels des betrachteten Signals, insbesondere innerhalb eines vordefinierten Zeitbereichs. Entsprechend werden dann zweckmäßigerweise das untere und das obere Ende des Dynamikbereichs der aktuellen akustischen Szene als Minimum und Maximum des Eingangssignals innerhalb eines vordefinierten Zeitbereichs ermittelt. Abseits der Nutzung von Minimum und Maximum des Pegels eines Signals als oberes und unteres Ende eines Dynamikbereichs sind aber auch andere Definitionen geeignet, insbesondere basierend auf einer statistischen Analyse. Beispielsweise entsprechen das obere und das untere Ende einem Streuungsmaß (z.B. Standardabweichung) der Pegelwerte ausgehend von einem Lagemaß (z.B. Median) der Pegelwerte, insbesondere innerhalb eines vordefinierten Zeitraums. Entsprechend werden in einer geeigneten Ausgestaltung das untere und das obere Ende des Dynamikbereichs der aktuellen akustischen Szene basierend auf einer statistischen Analyse des Eingangssignals ermittelt.

Vorliegend wird der Dynamikbereich der aktuellen akustischen Szene ermittelt, mit einem unteren Ende und einem oberen Ende. Mit anderen Worten: die aktuelle akustische Szene weist einen Dynamikbereich auf, welcher ermittelt wird, z.B. aus dem Eingangssignal abgeleitet wird, z.B. entweder direkt als Minimum und Maximum des Eingangssignals oder als Minimum und Maximum des AGC-Eingangssignals, welches seinerseits aus dem Eingangssignal abgeleitet ist. Der Dynamikbereich der aktuellen akustischen Szene wird auch als Szenendynamik bezeichnet. Die bereits genannte Eingangsdynamik oder eine davon abgeleitete Dynamik eignet sich besonders als Dynamikbereich der aktuellen akustischen Szene. Die Ermittlung der Szenendynamik ist zweckmäßigerweise ein Teil des hier beschriebenen Verfahrens. **In** einer geeigneten Ausgestaltung wird die Szenendynamik mit der Szenenerkennungseinheit oder mit der AGC-Einheit ermittelt.

Die szenenabhängige Parametrierung der AGC-Funktion eignet sich besonders dazu, die Szenendynamik optimal auf eine bestimmte, vorgegebene Ausgangsdynamik abzubilden, d.h. den Pegel des Ausgangssignals innerhalb eines entsprechenden Wertebereichs zu halten. Hierzu ist vorliegend eine Ausgangsdynamik vorgegeben, mit einem unteren Ende und einem oberen Ende. Die Parameter der AGC-Funktion werden dann derart eingestellt, dass diese den Dynamikbereich, d.h. hier die Szenendynamik, auf die Ausgangsdynamik abbildet. Insbesondere wird das untere Ende der Szenendynamik auf das untere Ende der Ausgangsdynamik abgebildet und das obere Ende der Szenendynamik auf das obere Ende der Ausgangsdynamik. Dazwischen, d.h. zwischen unterem und oberem Ende, erfolgt insbesondere eine lineare Abbildung. Dadurch wird eine optimale Überlappung von Szenendynamik und Ausgangsdynamik erzielt.

Vorliegend entspricht die Ausgangsdynamik einem Hörbereich des Nutzers. Die AGC-Funktion wird dann szenenabhängig derart angepasst, dass die Szenendynamik optimal auf den Hörbereich abgebildet wird. Die Parameter der AGC-Funktion werden derart eingestellt, dass die Ausgangsdynamik, welche ja letztendlich an den Nutzer ausgegeben wird, möglichst weitgehend dem Hörbereich entspricht, sodass dieser Hörbereich mit der Szenendynamik optimal überlappt und das Hörvermögen des Nutzers optimal ausgenutzt wird. Grundsätzlich ist es bereits vorteilhaft, wenn die Szenendynamik wenigstens überwiegend auf den Hörbereich abgebildet wird, vorzugsweise zu wenigstens 90%. Der Hörbereich ist definiert durch diejenigen Pegelwerte, welche vom Nutzer wahrnehmbar sind. Ein Signal mit einem Pegel innerhalb des Hörbereichs ist für den Nutzer hörbar, nicht aber ein Signal mit einem Pegel außerhalb davon. Entsprechend ist der Hörbereich für jeden Nutzer individuell und gegebenenfalls unterschiedlich. Ein Signal, dessen Dynamik zumindest teilweise außerhalb des Hörbereichs liegt, erscheint für den Nutzer gestört und ist für diesen unter Umständen schlecht verständlich. Ob ein Pegel hörbar ist oder nicht, ist notwendigerweise subjektiv. Der Hörbereich wird z.B. außerhalb des hier beschriebenen Verfahrens mittels eines geeigneten Hörtests bestimmt. Geeigneterweise wird oder ist der Hörbereich dann in dem Hörgerät gespeichert.

Die entsprechende AGC-Funktion zur Abbildung der Szenendynamik auf den Hörbereich kann nun grundsätzlich so verwendet werden. **In** einer vorteilhaften Ausgestaltung wird aber noch zusätzlich, z.B. als zusätzlicher Schritt nach oder während der Anpassung an den Hörbereich, die AGC-Funktion weiter angepasst, indem das untere Ende oder das obere Ende der Ausgangsdynamik verschoben wird, d.h. dass ein Unterschied zwischen dem unteren Ende oder oberen Ende des Hörbereichs und dem unteren Ende beziehungsweise oberen Ende der Ausgangsdynamik eingestellt wird, wie weiter unten noch im Detail beschrieben ist. Die Ausgangsdynamik unterscheidet sich dann zwar leicht von dem Hörbereich, auf diese Weise ist es aber möglich, Kammfiltereffekte zu reduzieren.

Die vorliegend genannten unteren und oberen Enden sind jeweils Pegelwerte (auch Lautstärkewerte), welche beispielsweise in dB angegeben sind. Entsprechend sind der Hörbereich und jegliche Dynamikbereiche jeweils ein Pegelbereich (auch Lautstärkebereich).

Für den Hörbereich (auch "Hördynamik") gelten die Ausführungen zum Dynamikbereich analog, mit dem Unterschied, dass der Hörbereich nicht auf einem tatsächlichen Signal basiert, sondern eine Eigenschaft des Nutzers angibt. Nichtsdestoweniger weist der Hörbereich ein unteres Ende (Minimum) und ein oberes Ende (Maximum) auf und gibt einen Wertebereich für einen Pegel an.

Oberes und unteres Ende des Hörbereichs können wie oben beim Dynamikbereich beschrieben bestimmt und definiert werden.

In einer geeigneten Ausgestaltung werden verschiedene Szenen "nominal" voneinander unterschieden, d.h. mittels eines Klassifikators, z.B. im Sinne von "laute Umgebung", "Sprache in Ruhe" usw. Alternativ oder zusätzlich werden verschiedene Szenen durch einen oder mehrere Kennwerte beschrieben, z.B. Geräuschpegel, SNR oder Dynamikbereich, wobei diese Kennwerte dann vorzugsweise zur Steuerung der Dynamik der AGC-Einheit verwendet werden. Die Abgrenzung verschiedener Szenen mittels Klassifikator ist auf unterschiedliche Weise geeignet realisierbar: z.B. mit Schwellwerten für die erwähnten Kennwerte (SNR usw.) oder als statistischer Klassifikator, welcher entweder die Kennwerte, das Eingangssignal oder eine abgewandelte Form des Eingangssignals statistisch analysiert und basierend darauf eine jeweilige Szene erkennt. Als Klassifikator ist auch ein trainierter Klassifikator geeignet, z.B. ein neuronales Netz oder Ähnliches. Auch die weiter unten erwähnte Sprachaktivität-Erkennungseinheit ist als Klassifikator zur Klassifizierung einer Szene geeignet. Vorliegend bezieht sich der Begriff "Szene" vorzugsweise speziell auf den jeweils relevanten Dynamikbereich, welcher frequenzspezifisch unterschiedlich sein kann und welcher sich vorteilhafterweise vorrangig am Dynamikbereich eines Zielsprechers orientiert und dann nachrangig auch am Dynamikbereich der akustischen Szene (Umgebung), d.h. von Umgebungsgeräusch oder dem aktuellen Geräuschpegel.

Eine für verschiedene Szenen fest vorgegebene, einzelne AGC-Funktion ermöglicht höchstens beschränkt eine Abbildung der Szenendynamik auf die vorgegebene Ausgangsdynamik, speziell den Hörbereich des Nutzers. Im Gegensatz dazu wird gemäß der vorliegenden Erfindung die AGC-Funktion je nach Bedarf angepasst. Dadurch wird die Akzeptanz zur Nutzung eines Hörgeräts verbessert.

Zweckmäßigerweise ist der Hörbereich ein komfortabler Hörbereich des Nutzers. Der komfortable Hörbereich ist insbesondere definiert mittels eines herkömmlichen Hörtests, bei welchem z.B. von einem Audiologen frequenzabhängig die Hörschwelle des Nutzers gemessen wird, welche eine untere Pegelgrenze der Wahrnehmung darstellt, sowie zusätzlich auch eine Unbehaglichkeitsschwelle (UCL) als obere Pegelgrenze. Zwischen diesen beiden Pegelgrenzen liegt der komfortable Hörbereich. Dieser kann grundsätzlich auch mit Hilfe eines Tests für den Bereich der sogenannten angenehmsten Lautheit (MCL) näher definiert werden. Alternativ oder zusätzlich ist der Dynamikbereich der aktuellen akustischen Szene ein relevanter Dynamikbereich dieser Szene, welcher sich insbesondere vorrangig am Dynamikbereich eines Zielsprechers orientiert und in zweckmäßigerweise zusätzlich noch nachrangig (z.B. in einer Szene ohne Sprache) am Dynamikbereich der Umgebung, d.h. von Umgebungsgeräuschen oder dem aktuellen Geräuschpegel.

In einer bevorzugten Ausgestaltung ist einer der Parameter ein erster Kniepunkt, welcher derart eingestellt wird, dass dieser an den unteren Enden des Dynamikbereichs (Szenendynamik) und der Ausgangsdynamik liegt, und ein weiterer der Parameter ist ein zweiter Kniepunkt, welcher derart eingestellt wird, dass dieser an den oberen Enden des Dynamikbereichs und der Ausgangsdynamik liegt. Der Dynamikbereich und die Ausgangsdynamik sind demnach von den beiden Kniepunkten eingefasst. Durch die beiden Kniepunkte ist die AGC-Funktion dreigeteilt, mit einem ersten Abschnitt zwischen den beiden Kniepunkten, einem zweiten Abschnitt nach dem zweiten Kniepunkt und einem dritten Abschnitt vor dem ersten Kniepunkt. Vorzugsweise sind alle drei Abschnitte gerade, d.h. linear. Der erste Abschnitt ist für den Nutzer am relevantesten, da dieser vorzugsweise die Verstärkung des AGC-Eingangssignals im Hörbereich bestimmt. Der zweite und der dritte Abschnitt definieren dann die Verstärkung des AGC-Eingangssignals außerhalb des Hörbereichs. Durch die beschriebene Einstellung der beiden Kniepunkte derart, dass diese die unteren und oberen Enden markieren, wird die Szenendynamik exakt auf die Ausgangsdynamik, speziell den Hörbereich, abgebildet.

In einer beispielhaften Ausgestaltung beträgt das untere Ende der Ausgangsdynamik 40 dB und das obere Ende der Ausgangsdynamik beträgt 60 dB. In einer ersten Szene beträgt das untere Ende des Dynamikbereichs (Szenendynamik) 20 dB und das obere Ende des Dynamikbereichs beträgt 80 dB. Dann ist die Steigung auf dem ersten Abschnitt < 1 und im Betrieb wird in dieser Szene der Dynamikbereich komprimiert, da dieser größer ist als die Ausgangsdynamik. In einer anderen, zweiten Szene beträgt dann das untere Ende des Dynamikbereichs 60 dB und das obere Ende des Dynamikbereichs beträgt 70 dB. Dann ist die Steigung auf dem ersten Abschnitt > 1 und im Betrieb wird in dieser Szene der Dynamikbereich expandiert, da dieser nun größer ist als die Ausgangsdynamik. Während sich der Dynamikbereich von Szene zu Szene ändert, bleibt die Ausgangsdynamik typischerweise unverändert.

In einer weiteren bevorzugten Ausgestaltung ist einer der Parameter ein Offset (gain shift), welcher auf einen Wert eingestellt wird, welcher einer Differenz aus den unteren Enden der Ausgangsdynamik, speziell des Hörbereichs, und des Dynamikbereichs entspricht. Mit anderen Worten: der Offset $g_{shift}$ ergibt sich aus dem untere Ende $o_{low}$ der Ausgangsdynamik und dem unteren Ende $d_{low}$ des Dynamikbereichs gemäß

$$g_{shift} = o_{low} - d_{low}.$$

Geeigneterweise wird das untere Ende der Ausgangsdynamik derart bestimmt, dass die Differenz zum unteren Ende des Dynamikbereichs einen Maximalwert nicht überschreitet. Der Offset wird demnach auf einen Maximalwert begrenzt. Auf diese Weise bleiben Unterschiede in der Verstärkung verschiedener Szenen zumindest qualitativ erhalten, was zu einer natürlicheren Wiedergabe der Szenen für den Nutzer führt. Das untere Ende der Ausgangsdynamik wird demnach abhängig von dem unteren Ende der Szenendynamik und dem Maximalwert gegebenenfalls effektiv verschoben und weicht dann von dem ursprünglich vorgegebenen unteren Ende der Ausgangsdynamik entsprechend ab.

In einer weiteren bevorzugten Ausgestaltung ist einer der Parameter eine erste Steigung, welche derart eingestellt wird, dass diese dem Verhältnis von einer Differenz von oberem und unterem Ende der Ausgangsdynamik, speziell des Hörbereichs, zu einer Differenz von oberem und unterem Ende des Dynamikbereichs (Szenendynamik) entspricht. Die erste Steigung $S_{hearing}$ ergibt sich aus oberem Ende $o_{high}$ und unterem Ende $o_{low}$ der Ausgangsdynamik sowie oberem Ende $d_{high}$ und unterem Ende $d_{low}$ des Dynamikbereichs gemäß

$$S_{hearing} = (o_{high} - o_{low}) / (d_{high} - d_{low})$$

Die erste Steigung ist demnach insbesondere die Steigung der AGC-Funktion auf dem weiter oben bereits genannten ersten Abschnitt zwischen den beiden Kniepunkten. Die erste Steigung gibt auch allgemein die Verstärkung der AGC-Einheit für Pegelwerte innerhalb der Szenendynamik an. Je nachdem wie groß der Dynamikbereich in einer gegebenen aktuellen akustischen Szene ist und wie groß die Ausgangsdynamik (speziell der individuelle Hörbereich) ist, ergibt sich dann eine Steigung von < 1, d.h. eine Kompression, oder von = 1, d.h. eine einfache Durchleitung, oder von > 1, d.h. eine Expansion. Optional wird die erste Steigung auf einen Maximalwert begrenzt, um mögliche Artefakte zu vermeiden. Der Maximalwert ist insbesondere > 1.

Zweckmäßigerweise wird ermittelt, ob in dem Eingangssignal Sprache vorhanden ist oder nicht, und die erste Steigung wird auf einen Wert von 1 begrenzt, falls in dem Eingangssignal keine Sprache vorhanden ist. Zur genannten Ermittlung, ob in dem Eingangssignal Sprache vorhanden ist oder nicht, wird vorzugsweise eine Sprachaktivität-Erkennungseinheit (voice activity detection unit) verwendet. Die Sprachaktivität-Erkennungseinheit ist insbesondere ein Teil der Signalverarbeitung und erhält zur Ermittlung, ob in dem Eingangssignal Sprache vorhanden ist oder nicht, das Eingangssignal oder ein davon abgeleitetes Signal. Die beschriebene Begrenzung von 1 im Falle eines Nicht-Vorhandenseins von Sprache begrenzt eine Expansion durch die AGC-Einheit auf solche Fälle, in welchen Sprache vorhanden ist.

In einer weiteren bevorzugten Ausgestaltung ist einer der Parameter eine zweite Steigung, welche derart eingestellt wird, dass diese dem Verhältnis von einer Differenz von einem maximalen Hörpegel und dem oberen Ende der Ausgangsdynamik, speziell des Hörbereichs, zu einer Differenz von einem maximalen Szenenpegel und dem oberem Ende des Dynamikbereichs entspricht. Die zweite Steigung gibt insbesondere die Verstärkung der AGC-Einheit entlang des zweiten Abschnitts, d.h. oberhalb des zweiten Kniepunkts, an. Die zweite Steigung $S_{loud}$ ergibt sich dann aus dem maximalen Hörpegel $h_{max}$, dem oberen Ende $o_{high}$ der Ausgangsdynamik, dem maximalen Szenenpegel $d_{max}$ und dem oberem Ende $d_{high}$ des Dynamikbereichs gemäß

$$S_{loud} = (h_{max} - o_{high}) / (d_{max} - d_{high})$$

Der maximale Hörpegel ist größer als das obere Ende der Ausgangsdynamik und gibt insbesondere einen insgesamt maximal zulässigen Pegel für das Ausgangssignal an. Der maximale Hörpegel ist insbesondere die sogenannte Unbehaglichkeitsschwelle (UCL), welche entweder gemessen oder approximiert wird. Beispielsweise beträgt der maximale Hörpegel 70 dB. Der maximale Szenenpegel ist insbesondere größer als das obere Ende des Dynamikbereichs, z.B. ist das obere Ende basierend auf einer statistischen Analyse bestimmt worden und der maximale Szenenpegel entspricht dann einem gemessenen, absoluten Maximum des Pegels der aktuellen akustischen Szene. Beispielsweise beträgt der maximale Szenenpegel 90 dB. Der maximale Szenenpegel ist beispielsweise als (frequenzspezifisch) höchster Eingangspegel innerhalb eines bestimmten Zeitraumes definiert. Wenn die AGC-Einheit an diesen maximalen Szenenpegel angepasst ist, bedeutet dies insbesondere, dass dieser und alle darunter liegenden Pegel von der AGC-Einheit in den Hörbereich transportiert werden. Darüber liegende (statistisch weniger wahrscheinliche) Pegel würden dann geeigneterweise in den Arbeitsbereich eines zusätzlichen Algorithmus fallen, z.B. eines "Output Limiter" oder "Maximum Power Output"-Limiter.

Vorzugsweise wird die zweite Steigung auf einen Wert von maximal 1 begrenzt, d.h. auf dem zweiten Abschnitt wird keine Expansion zugelassen.

Die erfindungsgemäße szenenabhängige Anpassung der AGC-Funktion ermöglicht auch die Reduzierung von Kammfiltereffekten. Ein Kammfiltereffekt ist ein Artefakt, welches durch die Überlagerung des Ausgangssignals des Hörgeräts mit einem Direktschallsignal, kurz Direktschall, ergibt. Der Direktschall erreicht den Gehörgang des Nutzers unter Umgehung des Hörgeräts, z.B. über einen Vent oder einen Dome eines Ohrstück des Hörgeräts. Aufgrund der Verarbeitung im Hörgerät ergibt sich zwischen dem Ausgangssignal und dem Direktschall ein Zeitversatzt, das Ausgangssignal ist typischerweise verzögert relativ zum Direktschall. Ein Kammfiltereffekt ist dann am auffälligsten, wenn die Hintergrundgeräusche der Szene stationär sind, d.h. eine nur geringe Variation aufweisen, und wenn der Direktschall und das Ausgangssignal einen ähnlich großen Pegel aufweisen. Der Pegel des Direktschallsignals wird auch als Direktschalpegel bezeichnet. Der Kammfiltereffekt ist demnach stark abhängig von Art und Pegel des Eingangssignals. Da die Verstärkung des Hörgeräts nutzerabhängig und gegebenenfalls nicht-linear ist, variieren die Kammfiltereffekte von Hörgerät zu Hörgerät, da diese abhängig vom Nutzer konfiguriert sind (sogenanntes Fitting/Anpassung). Entsprechend ist es schwierig, eine statische Lösung des Kammfilterproblems anzugeben.

Grundsätzlich ist es möglich, solche Frequenzbereiche, welche eine besonders hohe Anfälligkeit für Kammfiltereffekte aufweisen, bei der Anpassung des Hörgeräts an den Nutzer auszuschalten. Diese Frequenzbereiche sind dann aber konsequenterweise auch später von vorteilhaften Features wie Störgeräuschunterdrückung und anderen ausgenommen. Dieses Vorgehen berücksichtigt zudem nicht das situationsabhängige Auftreten von Kammfiltereffekten, nämlich die nichtlineare Beziehung zwischen Direktschallpegel und vom Hörgerät ausgegebenem Pegel des Ausgangssignals. Eine andere mögliche Lösung wäre entsprechend, mittels der Szenenerkennungseinheit einen Kammfiltereffekt vorherzusagen und dann situativ die potentiell betroffenen Frequenzbereiche abzuschalten. Eine solche Voraussage ist jedoch schwierig.

Vorliegend wird daher die einstellbare AGC-Funktion genutzt, um Kammfiltereffekte zu vermeiden. Entsprechend wird vorliegend der Direktschallpegel der aktuellen akustischen Szene ermittelt und der eine oder die mehreren Parameter der AGC-Funktion werden derart eingestellt, dass das untere Ende oder das obere Ende der Ausgangsdynamik einen vorgegebenen Mindestabstand zu dem Direktschallpegel aufweist. Dadurch wird für jede akustische Szene automatisch eine optimale AGC-Funktion ermittelt und eingestellt, womit dann das Auftreten eines Kammfiltereffekts vermieden wird. Dabei bleiben Sprache und Umgebungsgeräusche maximal erhalten, besonders dann, wenn zugleich auch wie bereits beschrieben die Szenendynamik möglichst optimal auf den Hörbereich abgebildet wird, nun jedoch unter Berücksichtigung potentieller Kammfiltereffekte. Dabei wird die Erkenntnis genutzt, dass Kammfiltereffekte am auffälligsten sind, wenn der Direktschallpegel ähnlich dem Pegel des Ausgangssignals ist und wenn die aktuelle akustische Szene ein stationäres Störgeräusch aufweist. In dieser Situation sind Kammfiltereffekte besonders störend und werden daher vorliegend besonders in einer solchen Situation vermieden. Dabei wird davon ausgegangen, dass ein stationäres Störgeräusch (z.B. stationäres Hintergrundgeräusch) das Minimum, d.h. das untere Ende, der Szenendynamik bildet. Dies wird auch als "noise floor" bezeichnet. Das stationäre Störgeräusch gelangt nun einerseits als Direktschall zum Nutzer, der Direktschallpegel entspricht dem tatsächlichen Pegel des stationären Störgeräuschs. Andererseits gelangt das Störgeräusch über das Hörgerät zum Nutzer, das untere Ende der Szenendynamik und damit das stationäre Störgeräusch wird nämlich mittels der AGC-Funktion auf das untere Ende der vorgegebenen Ausgangsdynamik abgebildet. Ein Kammfiltereffekt entsteht somit speziell dann, wenn der Direktschallpegel dem unteren Ende der Ausgangsdynamik ähnlich ist. Durch einen entsprechenden Mindestabstand zwischen dem unteren Ende der Ausgangsdynamik und dem Direktschallpegel wird somit das Risiko von Kammfiltereffekten reduziert.

Oben wurde als bevorzugter Anwendungsfall beschrieben, dass der Direktschallpegel ein Pegel eines stationären Störgeräuschs der akustischen Szene ist und/oder einem unteren Ende des Dynamikbereichs der Szene entspricht. Die Ausführungen, gelten aber analog auch für andere Direktschallsignale und auch analog für das obere Ende der Ausgangsdynamik, welches gegebenenfalls analog um verschoben wird, um einen Mindestabstand zum Direktschallpegel einzuhalten und dadurch Kammfiltereffekte oder einen anderen Effekt zu vermeiden.

Der Mindestabstand beträgt geeigneterweise wenigstens 3 dB. Vorzugsweise beträgt der Mindestabstand höchstens 6 dB. In welcher Richtung der Mindestabstand eingehalten wird, ist von untergeordneter Bedeutung. Tatsächlich kann das entsprechende Ende der Ausgangsdynamik so verschoben werden, dass der Direktschallpegel entweder innerhalb oder außerhalb der Ausgangsdynamik liegt, wichtig ist nur, dass der Mindestabstand eingehalten wird. Zweckmäßigerweise wird das entsprechende Ende der Ausgangsdynamik in diejenige Richtung verschoben, in welcher die geringere Änderung erforderlich ist. Beträgt beispielsweise der Direktschallpegel 59 dB und das untere Ende der Ausgangsdynamik 60 dB, dann wird das untere Ende um wenigstens 2 dB, besser 5 dB nach oben verschoben, d.h. auf 62 dB beziehungsweise 65 dB. Beträgt hingegen der Direktschallpegel beispielsweise 46 dB und das untere Ende der Ausgangsdynamik 45 dB, dann wird umgekehrt das untere Ende um wenigstens 2 dB, besser 5 dB nach unten verschoben, d.h. auf 43 dB beziehungsweise 40 dB.

Grundsätzlich kann der Direktschallpegel auf verschiedene Weisen ermittelt werden. Die Ermittlung des Direktschallpegels ist aber grundsätzlich schwierig und fehleranfällig. Vorliegend wird daher vorteilhafterweise einfach der Direktschallpegel ermittelt, indem das untere Ende (Minimum) des Dynamikbereichs (Szenendynamik) gemessen wird und als Direktschallpegel verwendet wird. Zweckmäßigerweise ist der Direktschallpegel ein Pegel eines stationären Störgeräuschs der akustischen Szene, in welchem Fall die vorgenannte Näherung besonders gerechtfertigt ist. Diese Methode ist besonders robust, ein abschalten einzelner Frequenzbereiche ist nicht erforderlich. Stattdessen basiert das hier beschriebene Konzept insbesondere alleinig auf der szenenabhängigen Anpassung der AGC-Funktion. Die zusätzliche Anpassung zur Vermeidung von Kammfiltereffekten erfolgt auch vorteilhaft am unteren Ende der Szenendynamik, d.h. am Störgeräuschende der akustischen Szene, während das obere Ende, welches besonders relevant für die Sprachausgabe ist, geeigneterweise unbeeinflusst von jeglicher Korrektur zur Vermeidung von Kammfiltereffekten bleibt. Damit werden Kammfiltereffekte reduziert und zugleich bleiben Sprachverständlichkeit und Geräuschqualität maximal erhalten.

Beispielsweise wird das obige Konzept umgesetzt, indem zunächst geprüft wird, ob der absolute Unterschied zwischen unterem Ende der Ausgangsdynamik und Direktschallpegel weniger als dem Mindestabstand entspricht, z.B. wie folgt:

$$|o_{low} - n_{low}| < 6 \text{ dB?}$$

wobei $n_{low}$ der Direktschallpegel ist und $n_{low} = dl_{ow}$ angenommen wird, d.h. der Direktschallpegel wird als stationäres Hintergrundgeräusch am unteren Ende der Szenendynamik angenommen. Falls nun zusätzlich vorliegt, dass

$$n_{low} \geq o_{low},$$

dann wird

$$o_{low} = n_{low} - 6 \text{ dB}$$

gesetzt. Falls umgekehrt zusätzlich vorliegt, dass

$$n_{low} < o_{low},$$

dann wird

$$o_{low} = n_{low} + 6 \text{ dB}$$

gesetzt.

In einer geeigneten Ausgestaltung werden die Parameter frequenzabhängig eingestellt. Mit anderen Worten: das AGC-Eingangssignal oder bereits das Eingangssignal wird auf mehrere Frequenzbereiche aufgeteilt, z.B. mittels einer Filterbank, welche insbesondere ein Teil der Signalverarbeitung ist. Die Parameter werden dann für jeden der Frequenzbereiche separat eingestellt, sodass für jeden einzelnen Frequenzbereich eine eigene AGC-Funktion verwendet wird.

Vorteilhaft ist auch eine Berücksichtigung der Höranstrengung (äquivalent: Erschöpfung) des Nutzers bei der Einstellung der Parameter. **In** einer geeigneten Ausgestaltung wird entsprechend eine Höranstrengung des Nutzers ermittelt und einer oder mehrere der Parameter werden zusätzlich (d.h. zusätzlich zur Szenenabhängigkeit) abhängig von der Höranstrengung eingestellt. Beispielsweise werden hierbei mittels eines psychoakustischen Models das obere und/oder untere Ende der Ausgangsdynamik modifiziert, sodass diese dann von den ursprünglich vorgegebenen Werten gegebenenfalls abweichen. So ist es vorteilhaft, wenn das obere Ende der Ausgangsdynamik reduziert wird, d.h. zu einem niedrigeren Pegelwert hin verschoben wird, falls die Höranstrengung während eines bestimmten vorangegangenen Zeitabschnitts von z.B. 15 min groß war, d.h. einen entsprechenden Schwellwert überschritten hat. Alternativ oder zusätzlich ist es umgekehrt vorteilhaft, wenn das untere Ende der Ausgangsdynamik erhöht wird, d.h. zu einem höheren Pegelwert hin verschoben wird, falls die Höranstrengung während eines bestimmten vorangegangenen Zeitabschnitts von z.B. 15 min gering war, d.h. einen entsprechenden Schwellwert unterschritten hat. Die Höranstrengung wird beispielsweise einfach anhand des mittleren Pegels der Szene bestimmt, wobei dann davon ausgegangen wird, dass bei einem mittleren Pegel oberhalb eines bestimmten Grenzwerts eine hohe Höranstrengung vorliegt und umgekehrt bei einem mittleren Pegel unterhalb eines bestimmten Grenzwerts eine geringe Höranstrengung.

Nachfolgend werden Ausführungsbeispiele der Erfindung anhand einer Zeichnung näher erläutert. Darin zeigen jeweils schematisch:

Fig. 1    ein Hörgerät,

Fig. 2    ein Verfahren zum Betrieb des Hörgeräts aus Fig. 1,

Fig. 3    eine AGC-Funktion, parametriert für eine erste Szene,

Fig. 4    die AGC-Funktion aus Fig. 3, parametriert für eine andere, zweite Szene,

Fig. 5a    die AGC-Funktion aus Fig. 3, parametriert für eine dritte Szene,

Fig. 5b    die AGC-Funktion aus Fig. 5a, zusätzlich angepasst zur Reduzierung von Kammfiltereffekten,

Fig. 6a    die AGC-Funktion aus Fig. 3, parametriert für eine vierte Szene,

Fig. 6b    die AGC-Funktion aus Fig. 6a, zusätzlich angepasst zur Reduzierung von Kammfiltereffekten.

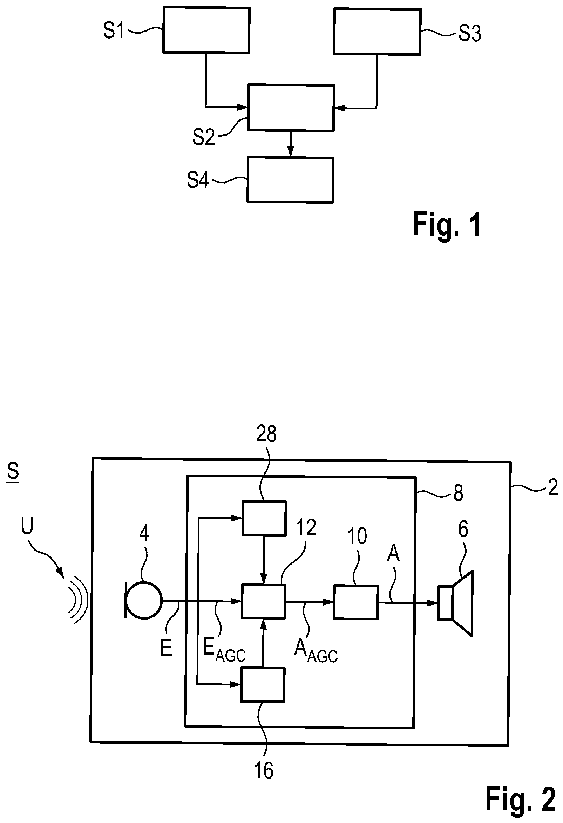

In Fig. 1 ist ein Ausführungsbeispiel für ein Hörgerät 2 gezeigt, welches einem nicht explizit dargestellten Nutzer zugeordnet. Das Hörgerät 2 ist lediglich diesem einen Nutzer zugeordnet und wird lediglich von diesem verwendet. Im hier gezeigten Ausführungsbeispiel dient das Hörgerät 2 zur Versorgung eines hörgeschädigten Nutzers und zum Ausgleich eines Hörverlusts dieses Nutzers. Im Betrieb trägt und verwendet der Nutzer das Hörgerät 2 beispielsweise am Kopf und im oder am Ohr.

Das Hörgerät 2 weist einen Eingangswandler 4, hier ein Mikrofon, einen Ausgangswandler 6, hier einen Hörer, und eine Signalverarbeitung 8 auf (auch als Signalverarbeitungseinheit bezeichnet). Im Betrieb erzeugt der Eingangswandler 4 ein Eingangssignal E, welches der Signalverarbeitung 8 zugeführt wird. Diese modifiziert das Eingangssignal E und erzeugt dadurch schließlich ein Ausgangssignal A. Zum Ausgleich eines Hörverlusts wird das Eingangssignal R oder ein davon abgeleitetes Signal gemäß einem Audiogramm des Nutzers mit einem frequenzabhängigen Verstärkungsfaktor verstärkt, z.B. mit einer Verstärkungseinheit 10. Das Ausgangssignal A wird schließlich mittels des Ausgangswandlers 8 an den Nutzer ausgegeben.

In Fig. 2 ist ein beispielhaftes Verfahren zum Betrieb des Hörgeräts 2 gezeigt. Im Schritt S1 nimm das Hörgerät 2 mit dem Eingangswandler 4 ein Audiosignal U auf, und erzeugt daraus das Eingangssignal E. Aus diesem wird ein AGC-Eingangssignal $E_{AGC}$ erzeugt, welches einer AGC-Einheit 12 des Hörgeräts 2 zugeführt wird. In der einfachsten Ausgestaltung ist das AGC-Eingangssignal $E_{AGC}$ identisch zum Eingangssignal E, alternativ wird lediglich ein Teil des Eingangssignals E als AGC-Eingangssignal $E_{AGC}$ verwendet oder das Eingangssignal E wird zuvor noch durch eine andere Einheit der Signalverarbeitung 8 modifiziert und dann als AGC-Eingangssignal $E_{AGC}$ verwendet. Die AGC-Einheit 12 ist ein Teil der Signalverarbeitung 8 und in Fig. 1 vor, alternativ nach oder parallel zu der Verstärkungseinheit 10 angeordnet.

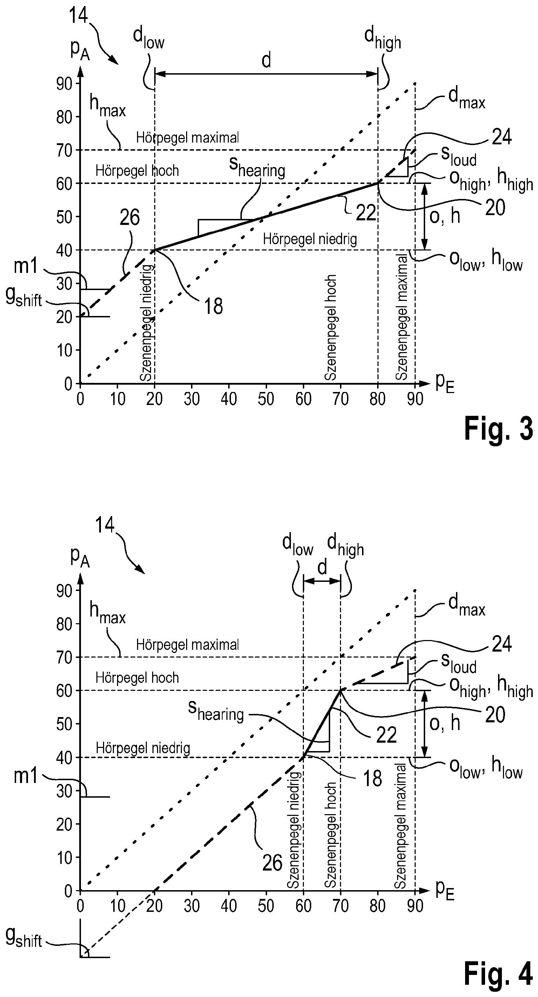

Die AGC-Einheit 12 verstärkt das AGC-Eingangssignal $E_{AGC}$ abhängig von einem Pegel $p_E$ des AGC-Eingangssignals $E_{AGC}$ und gemäß einer AGC-Funktion 14 und gibt dann das entsprechend verstärkte AGC-Eingangssignal $E_{AGC}$ als ein AGC-Ausgangssignal $A_{AGC}$ aus. Sechs Ausführungsbeispiele für die AGC-Funktion 14 sind in den Fig. 3 bis 5b gezeigt. Die AGC-Funktion 14 ordnet jedem Pegel pE, genauer jedem Pegelwert des Eingangssignals E oder AGC-Eingangssignals $E_{AGC}$ einen Pegel $p_A$ zu, genauer Pegelwert des Ausgangssignals A oder AGC-Ausgangssignals $A_{AGC}$. Das Verhältnis dieser beiden Pegelwerte $p_E$, $p_A$ ergibt eine Verstärkung, welche mit der AGC-Einheit 12 für einen entsprechenden Pegelwert des AGC-Eingangssignals $E_{AGC}$ angewendet wird, um dieses zu verstärken. Die Verstärkung kann grundsätzlich kleiner, größer oder gleich 1 sein, d.h. gegebenenfalls erfolgt eine Abschwächung und Kompression (< 1), eine bloße Durchleitung (= 1) oder eben eine echte Verstärkung und Expansion (> 1).

Die AGC-Funktion 14 ist durch einen oder mehrere Parameter 18, 20, $g_{shift}$, $S_{hearing}$, $S_{loud}$ definiert, wobei vorliegend ohne Beschränkung der Allgemeinheit von mehreren Parametern P ausgegangen wird. Die Parameter definieren die Form oder den Verlauf der AGC-Funktion 14 und werden daher auch als AGC-Parameter bezeichnet. Diese Parameter sind einstellbar, um die AGC-Funktion 14 und damit die Modifizierung des AGC-Eingangssignals $E_{AGC}$ durch die AGC-Einheit 12 zu verändern. Vorliegend werden im Schritt S2 die Parameter abhängig von einer akustischen Szene S eingestellt, welche aktuell vorliegt, d.h. abhängig von einer aktuellen akustischen Szene S. Als akustische Szene S (kurz lediglich "Szene") wird allgemein eine akustische Umgebung verstanden, in welcher sich der Nutzer potentiell befindet. Die aktuelle akustische Szene S ist dann diejenige akustische Umgebung, in welcher sich der Nutzer und damit auch das Hörgerät 2 zum aktuellen Zeitpunkt tatsächlich befinden. Die akustische Umgebung und damit die Szene S ist definiert durch jegliche Schallsignale, sowohl Nutzgeräusche als auch Störgeräusche, welche gegebenenfalls in unterschiedlicher Intensität und/oder aus unterschiedlichen Richtungen zum Nutzer und dem Hörgerät 2 gelangen, sowie auch durch jegliche akustischen Eigenschaften der Umgebung.

Die akustische Szene S, welche aktuell vorliegt, wird im hier gezeigten Ausführungsbeispiel im Schritt S3 mittels einer Szenenerkennungseinheit 16 bestimmt. Das Eingangssignal E oder ein davon abgeleitetes Signal wird der Szenenerkennungseinheit 16 zugeführt, welche dann anhand davon die Szene S bestimmt. Die AGC-Einheit 12 ist mit der Szenenerkennungseinheit 16 verbunden und wird von dieser gesteuert, d.h. es erfolgt eine automatische Einstellung der Parameter abhängig von der Bestimmung der aktuellen akustischen Szene S. Die Szenenerkennungseinheit 16 gibt ein Steuersignal aus, welches von der jeweiligen Szene S abhängig ist und von der AGC-Einheit 12 empfangen wird, um dann die Parameter szenenabhängig einzustellen.

Schließlich erzeugt das Hörgerät 2 im Schritt S4 aus dem AGC-Ausgangssignal $A_{AGC}$ ein Ausgangssignal A, zur Ausgabe an den Nutzer. **In** der einfachsten Ausgestaltung ist das Ausgangssignal A identisch zum AGC-Ausgangssignal $A_{AGC}$. Alternativ wird lediglich ein Teil des AGC-Ausgangssignals $A_{AGC}$ als Ausgangssignal A verwendet oder das AGC-Ausgangssignal $A_{AGC}$ wird - wie in Fig. 2 gezeigt - zuvor noch durch eine andere Einheit der Signalverarbeitung 8 modifiziert, z.B. die Verstärkungseinheit 10, und dann als Ausgangssignal A verwendet.

Das AGC-Eingangssignal $E_{AGC}$ (und allgemein das Eingangssignal E) weist eine Eingangsdynamik d auf und das AGC-Ausgangssignal $A_{AGC}$ (und allgemein das Ausgangssignal A) weist eine Ausgangsdynamik o auf und die AGC-Funktion 14 bildet die Eingangsdynamik d auf die Ausgangsdynamik o ab. Die Eingangsdynamik d und die Ausgangsdynamik o werden allgemein auch jeweils als "Dynamik" oder "Dynamikbereich" bezeichnet. Die Begriffe "Dynamik" und "Dynamikbereich" werden vorliegend synonym verwendet und meinen ein Maß für einen Wertebereich, welcher durch einen veränderlichen Pegel eines Signals (z.B. Eingangssignal E, Ausgangssignal A, AGC-Eingangssignal $E_{AGC}$, AGC-Ausgangssignal $A_{AGC}$) abgedeckt wird. Mit dem Begriff "unteres Ende" ist dann ein Minimum des Dynamikbereichs d gemeint, mit dem Begriff "oberes Ende" analog ein Maximum. In einer besonders einfachen Ausgestaltung entsprechen das untere und das obere Ende $d_{low}$, $d_{high}$ des Dynamikbereichs d einem Minimum beziehungsweise einem Maximum des Pegels des betrachteten Signals, beispielsweise des Eingangssignals E oder des AGC-Eingangssignals $E_{AGC}$. Als oberes und unteres Ende $d_{high}$, $d_{low}$ des Dynamikbereichs d sind aber auch andere Definitionen geeignet, z.B. basierend auf einer statistischen Analyse, sodass dann das untere und das obere Ende $d_{low}$, $d_{high}$ des Dynamikbereichs d der aktuellen akustischen Szene S basierend auf einer statistischen Analyse des Eingangssignals E ermittelt werden. Analog weist auch die Ausgangsdynamik o ein oberes Ende $o_{high}$ und ein unteres Ende $o_{low}$ auf.

Vorliegend bildet die AGC-Funktion 14 den Dynamikbereich d auf die Ausgangsdynamik o ab. Darunter wird verstanden, dass das untere Ende $d_{low}$ des Dynamikbereichs d auf das untere Ende $o_{low}$ der Ausgangsdynamik o abgebildet wird und das obere Ende $d_{high}$ des Dynamikbereichs d auf das obere Ende $o_{high}$ der Ausgangsdynamik o. Dazwischen, d.h. zwischen unterem und oberem Ende $d_{low}$, $o_{low}$, $d_{high}$, $o_{high}$, erfolgt eine lineare Abbildung. Dadurch wird eine optimale Überlappung von Szenendynamik d und Ausgangsdynamik o erzielt und insbesondere das Hörvermögen des Nutzers optimal ausgenutzt.

Die aktuelle akustische Szene S weist den Dynamikbereich d auf, welcher ermittelt wird, z.B. aus dem Eingangssignal E abgeleitet wird, z.B. entweder direkt als Minimum und Maximum des Eingangssignals E oder als Minimum und Maximum des AGC-Eingangssignals $E_{AGC}$, welches seinerseits aus dem Eingangssignal E abgeleitet ist. Der Dynamikbereich d der aktuellen akustischen Szene S wird auch als Szenendynamik bezeichnet. Die bereits genannte Eingangsdynamik oder eine davon abgeleitete Dynamik eignet sich besonders als Dynamikbereich d der aktuellen akustischen Szene S. Die Ermittlung der Szene S und deren Dynamikbereichs d ist ein Teil des hier beschriebenen Verfahrens und erfolgt im Schritt S2 oder im Schritt S3.

Die szenenabhängige Parametrierung der AGC-Funktion 14 eignet sich dazu, die Szenendynamik auf eine bestimmte, vorgegebene Ausgangsdynamik o abzubilden, d.h. den Pegel $p_A$ des Ausgangssignals A innerhalb eines entsprechenden Wertebereichs zu halten. Hierzu ist eine Ausgangsdynamik o vorgegeben. Die Parameter der AGC-Funktion 14 werden dann derart eingestellt, dass diese den Dynamikbereich d, d.h. hier die Szenendynamik, auf die Ausgangsdynamik o abbildet. Vorliegend wird das untere Ende $d_{low}$ der Szenendynamik auf das untere Ende $o_{low}$ der Ausgangsdynamik o abgebildet und das obere Ende $d_{high}$ der Szenendynamik auf das obere Ende $o_{high}$ der Ausgangsdynamik o. Dazwischen erfolgt eine lineare Abbildung. Insgesamt wird eine optimale Überlappung von Szenendynamik und Ausgangsdynamik o erzielt.

In den Fig. 3, 4, 5a, 6a sind Ausführungsbeispiele gezeigt, bei welchen die Ausgangsdynamik o exakt einem Hörbereich h des Nutzers entspricht. Die AGC-Funktion 14 wird szenenabhängig derart angepasst, dass die Szenendynamik optimal auf diesen Hörbereich h abgebildet wird. Die Parameter der AGC-Funktion 14 werden derart eingestellt, dass die Ausgangsdynamik o, welche ja letztendlich an den Nutzer ausgegeben wird, möglichst weitgehend dem Hörbereich h entspricht, sodass dieser Hörbereich h mit der Szenendynamik optimal überlappt und das Hörvermögen des Nutzers optimal ausgenutzt wird. Grundsätzlich ist es aber bereits vorteilhaft, wenn die Szenendynamik wenigstens überwiegend auf den Hörbereich h abgebildet wird, z.B. zu wenigstens 90%.

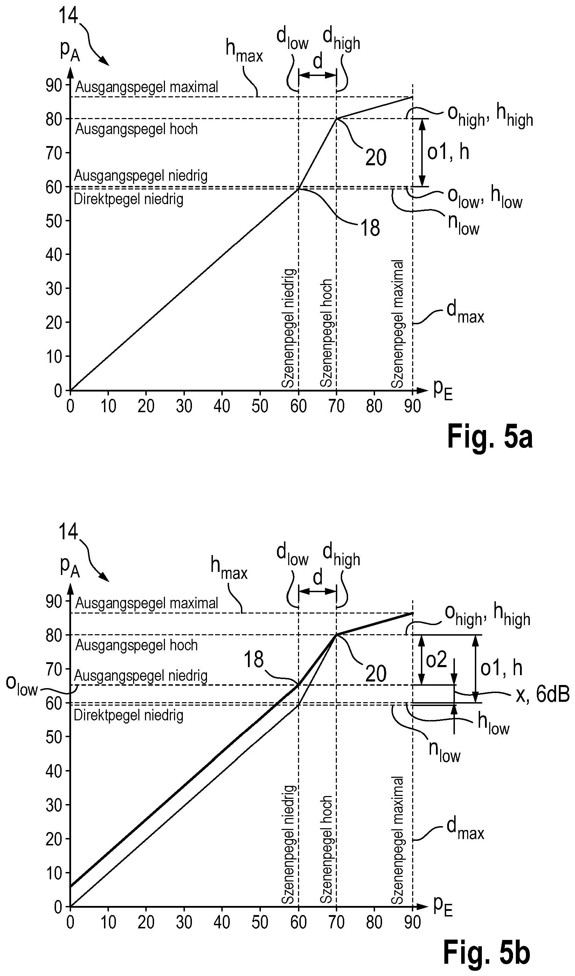

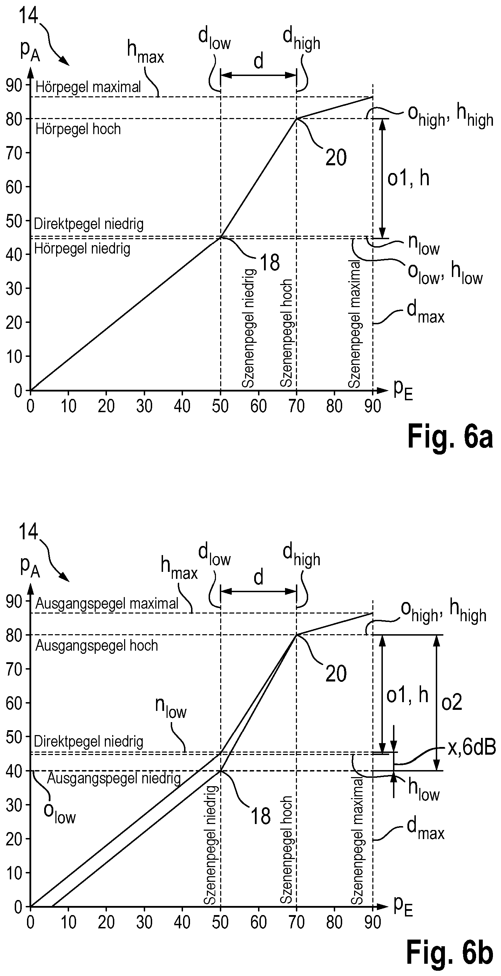

Der Hörbereich h ist definiert durch diejenigen Pegelwerte, welche vom Nutzer wahrnehmbar sind. Ein Signal mit einem Pegel innerhalb des Hörbereichs h ist für den Nutzer hörbar, nicht aber ein Signal mit einem Pegel außerhalb davon. Entsprechend ist der Hörbereich h für jeden Nutzer individuell und gegebenenfalls unterschiedlich. Ein Signal, dessen Dynamik zumindest teilweise außerhalb des Hörbereichs h liegt, erscheint für den Nutzer gestört und ist für diesen unter Umständen schlecht verständlich. Der Hörbereich h wird z.B. außerhalb des hier beschriebenen Verfahrens mittels eines geeigneten Hörtests bestimmt. Vorliegend ist der Hörbereich h in dem Hörgerät 2 gespeichert. Zwei Ausführungsbeispiele, bei welchen die Ausgangsdynamik o dem Hörbereich h entspricht, sodass effektiv die Szenendynamik auf den Hörbereich h abgebildet wird, sind in den Fig. 3 und 4 für zwei unterschiedliche Szenen S illustriert. Auch die Fig. 5a und 6a zeigen je ein Ausführungsbeispiel, bei welchem die Szenendynamik effektiv auf den Hörbereich h abgebildet wird. Da in diesen beiden Szenen S aber die Gefahr von Kammfiltereffekten besteht, wird hier die AGC-Funktion 14 noch zusätzlich angepasst, um eine leicht veränderte Ausgangsdynamik o zu erzielen, um Kammfiltereffekte zu reduzieren. Das Ergebnis hiervon ist in den Fig. 5b und 6b gezeigt. In den Fig. 5b und 6b wird somit als zusätzlicher Schritt nach oder während der Anpassung an den Hörbereich h, die AGC-Funktion 14 weiter angepasst, indem hier konkret jeweils das untere Ende $o_{low}$ (alternativ oder zusätzlich das obere Ende $o_{high}$) der Ausgangsdynamik o verschoben wird, d.h. ein Unterschied zwischen einem unteren Ende $h_{low}$ des Hörbereichs h und dem unteren Ende $o_{low}$ der Ausgangsdynamik o wird eingestellt. Dies ist weiter unten noch im Detail beschrieben. Die Ausgangsdynamik o unterscheidet sich dann zwar leicht von dem Hörbereich h, auf diese Weise ist es aber möglich, Kammfiltereffekte zu reduzieren.

Für den Hörbereich h gelten die Ausführungen zur Dynamik analog, mit dem Unterschied, dass der Hörbereich h nicht auf einem tatsächlichen Signal basiert, sondern eine Eigenschaft des Nutzers angibt. Nichtsdestoweniger weist der Hörbereich h ein unteres Ende $h_{low}$ (Minimum) und ein oberes Ende $h_{high}$ (Maximum) auf und gibt einen Wertebereich für einen Pegel an. Bei der genannten Abbildung der Szenendynamik d auf den Hörbereich h werden die Parameter der AGC-Funktion 14 derart eingestellt, dass ein Dynamikbereich d des Ausgangssignals A, welches ja an den Nutzer ausgegeben wird, dem Hörbereich h entspricht, sodass dieser mit der Szenendynamik d optimal überlappt.

Vorliegend wird die AGC-Funktion 14 und damit das Verhalten der AGC-Einheit 12 lediglich dann geändert, wenn sich auch die Szene S ändert, wenn also mit der Szenenerkennungseinheit 16 eine Änderung der aktuellen akustischen Szene S erkannt wird. Innerhalb derselben Szene S wird hingegen durchgängig dieselbe AGC-Funktion 14 verwendet, diese ist jedoch durch die szenenabhängige Einstellung der Parameter auf die Szene S optimiert. Durch die Einstellung der Parameter abhängig von der aktuellen akustischen Szene S wird die AGC-Funktion 14 an die Szene S angepasst. Dies führt gegebenenfalls sogar zu einer Expansion (Verstärkung > 1), in welchem Fall dann das SNR der aktuellen akustischen Szene S entsprechend vergrößert wird, während aber die Dynamik des Ausgangssignals A weiterhin auf den Hörbereich h des Nutzers beschränkt ist.

In der hier gezeigten Ausgestaltung ist einer der Parameter ein erster Kniepunkt 18, welcher derart eingestellt wird, dass dieser an den unteren Enden $d_{low}$, $h_{low}$ des Dynamikbereichs d und der Ausgangsdynamik o liegt, und ein weiterer der Parameter ist ein zweiter Kniepunkt 20, welcher derart eingestellt wird, dass dieser an den oberen Enden $d_{high}$, $h_{high}$ des Dynamikbereichs d und der Ausgangsdynamik o liegt. Dies ist in den Fig. 3 und 4 erkennbar. Der Dynamikbereich d und der Hörbereich h sind demnach von den beiden Kniepunkten 18, 20 eingefasst. Durch die beiden Kniepunkte 18, 20 ist die AGC-Funktion 14 dreigeteilt, mit einem ersten Abschnitt 22 zwischen den beiden Kniepunkten 18, 20, einem zweiten Abschnitt 24 nach dem zweiten Kniepunkt 20 und einem dritten Abschnitt 26 vor dem ersten Kniepunkt 18. Alle drei Abschnitte 22, 24, 26 sind gerade, d.h. linear. Der erste Abschnitt 22 ist für den Nutzer am relevantesten, da dieser die Verstärkung des AGC-Eingangssignals $E_{AGC}$ in der Ausgangsdynamik o bestimmt. Der zweite und der dritte Abschnitt 24, 26 definieren dann die Verstärkung des AGC-Eingangssignals $E_{AGC}$ außerhalb der Ausgangsdynamik o. Durch die beschriebene Einstellung der beiden Kniepunkte 18, 20 derart, dass diese die unteren und oberen Enden $d_{low}$, $h_{low}$, $d_{high}$, $h_{high}$ markieren, wird die Szenendynamik d in den Fig. 3, 4, 5a, 6a exakt auf den Hörbereich h abgebildet.

In den Fig. 3 und 4 beträgt das untere Ende $h_{low}$ des Hörbereichs h beispielhaft 40 dB und das obere Ende $h_{high}$ beträgt 60 dB. Die Ausgangsdynamik o ist identisch zum Hörbereich h In Fig. 3 ist dann beispielhaft die AGC-Funktion 14 in einer ersten Szene S gezeigt, in welcher das untere Ende $d_{low}$ des Dynamikbereichs d 20 dB beträgt und das obere Ende $d_{high}$ 80 dB. Dann ist die Steigung auf dem ersten Abschnitt 22 < 1 und im Betrieb wird in dieser Szene S der Dynamikbereich d komprimiert, da dieser größer ist als die Ausgangsdynamik o und der Hörbereich h. In Fig. 4 ist dann beispielhaft die AGC-Funktion 14 in einer anderen, zweiten Szene S gezeigt, in welcher das untere Ende $d_{low}$ des Dynamikbereichs d 60 dB beträgt und das obere Ende $d_{high}$ 70 dB. Dann ist die Steigung auf dem ersten Abschnitt 22 > 1 und im Betrieb wird in dieser Szene S der Dynamikbereich d expandiert, da dieser nun größer ist als die Ausgangsdynamik o und der Hörbereich h. Während sich der Dynamikbereich d von Szene S zu Szene S ändert, bleiben die Ausgangsdynamik o und der Hörbereich h unverändert.

Vorliegend ist einer der Parameter ein Offset $g_{shift}$, welcher auf einen Wert eingestellt wird, welcher einer Differenz aus den unteren Enden $h_{low}$, $d_{low}$ der Ausgangsdynamik o und des Dynamikbereichs d entspricht. Beispielsweise wird das untere Ende $o_{low}$ der Ausgangsdynamik o derart bestimmt, dass die Differenz zum unteren Ende $d_{low}$ des Dynamikbereichs d einen Maximalwert m1 nicht überschreitet.

Außerdem ist vorliegend noch einer der Parameter eine erste Steigung $S_{hearing}$, welche derart eingestellt wird, dass diese dem Verhältnis von einer Differenz von oberem und unterem Ende $o_{high}$, $o_{low}$ der Ausgangsdynamik o zu einer Differenz von oberem und unterem Ende $d_{high}$, $d_{low}$ des Dynamikbereichs d entspricht. Die erste Steigung $S_{hearing}$ ist demnach die Steigung der AGC-Funktion 14 auf dem ersten Abschnitt 22, welche ganz allgemein die Verstärkung der AGC-Einheit 12 für Pegelwerte innerhalb des Szenendynamik d angibt. Je nachdem wie groß der Dynamikbereich d in einer gegebenen aktuellen akustischen Szene S ist und wie groß die Ausgangsdynamik o und speziell der individuelle Hörbereich h sind, ergibt sich dann eine Steigung $S_{hearing}$ von < 1, d.h. eine Kompression wie in Fig. 3, = 1, d.h. eine einfache Durchleitung, oder > 1, d.h. eine Expansion wie in Fig. 4. Optional wird die erste Steigung $S_{hearing}$ auf einen Maximalwert begrenzt.

Im hier gezeigten Ausführungsbeispiel wird zusätzlich ermittelt, ob in dem Eingangssignal E Sprache vorhanden ist oder nicht, und die erste Steigung $S_{hearing}$ wird auf einen Wert von 1 begrenzt, falls in dem Eingangssignal E keine Sprache vorhanden ist. Zur Ermittlung, ob in dem Eingangssignal E Sprache vorhanden ist oder nicht, wird eine Sprachaktivität-Erkennungseinheit 28 verwendet.

Weiterhin ist vorliegend einer der Parameter eine zweite Steigung $s_{loud}$, welche derart eingestellt wird, dass diese dem Verhältnis von einer Differenz von einem maximalen Hörpegel $h_{max}$ und dem oberen Ende $o_{high}$ der Ausgangsdynamik o zu einer Differenz von einem maximalen Szenenpegel $d_{max}$ und dem oberem Ende $d_{high}$ des Dynamikbereichs d entspricht. Die zweite Steigung $S_{loud}$ gibt die Verstärkung der AGC-Einheit 12 entlang des zweiten Abschnitts 24 an. In den Fig. 3 und 4 beträgt der maximale Hörpegel $h_{max}$ 70 dB und der maximale Szenenpegel $d_{max}$ 90 dB.

Optional wird die zweite Steigung $S_{loud}$ auf einen Wert von maximal 1 begrenzt, d.h. auf dem zweiten Abschnitt 24 wird keine Expansion zugelassen.

Die szenenabhängige Anpassung der AGC-Funktion 14 ermöglicht auch die Reduzierung von Kammfiltereffekten, was nachfolgend näher anhand der Fig. 5a, 5b, 6a, 6b erläutert wird. Dabei zeigen die Fig. 5a, 5b eine Kantinenszene (cantine scene), die Fig. 6a, 6b eine Straßenszene (highway scene). Ein Kammfiltereffekt ist ein Artefakt, welches durch die Überlagerung des Ausgangssignals A mit einem Direktschallsignal, kurz Direktschall, ergibt. Ein Kammfiltereffekt ist dann am auffälligsten, wenn die Hintergrundgeräusche der Szene S stationär sind, d.h. eine nur geringe Variation aufweisen, und wenn der Direktschall und das Ausgangssignal A einen ähnlich großen Pegel aufweisen. Der Pegel $n_{low}$ des Direktschallsignals wird auch als Direktschalpegel $n_{low}$ bezeichnet.

Vorliegend wird die einstellbare AGC-Funktion 14 genutzt, um Kammfiltereffekte zu vermeiden. Hierzu wird zunächst der Direktschallpegel $n_{low}$ der aktuellen akustischen Szene S ermittelt und der eine oder die mehreren Parameter der AGC-Funktion 14 werden derart eingestellt, dass das untere Ende $o_{low}$ oder das obere Ende $o_{high}$ der Ausgangsdynamik o einen vorgegebenen Mindestabstand x zu dem Direktschallpegel $n_{low}$ aufweist. Dadurch wird für jede akustische Szene S automatisch eine optimale AGC-Funktion 14 ermittelt und eingestellt, womit dann das Auftreten eines Kammfiltereffekts vermieden wird. Dabei bleiben Sprache und Umgebungsgeräusche maximal erhalten, besonders dann, wenn zugleich auch wie bereits beschrieben die Szenendynamik möglichst optimal auf den Hörbereich h abgebildet wird, nun jedoch unter Berücksichtigung potentieller Kammfiltereffekte. Dabei wird die Erkenntnis genutzt, dass Kammfiltereffekte am auffälligsten sind, wenn der Direktschallpegel $n_{low}$ ähnlich dem Pegel $p_A$ des Ausgangssignals o ist und wenn die aktuelle akustische Szene S ein stationäres Störgeräusch aufweist. Konkret wird daher vorliegend davon ausgegangen, dass ein stationäres Störgeräusch (z.B. stationäres Hintergrundgeräusch) das Minimum, d.h. das untere Ende $d_{low}$, der Szenendynamik bildet. Dies wird auch als "noise floor" bezeichnet. Das stationäre Störgeräusch gelangt nun einerseits als Direktschall zum Nutzer, der Direktschallpegel $n_{low}$ entspricht dem tatsächlichen Pegel des stationären Störgeräuschs. Andererseits gelangt das Störgeräusch über das Hörgerät 2 zum Nutzer, das untere Ende $d_{low}$ der Szenendynamik und damit das stationäre Störgeräusch wird mittels der AGC-Funktion 14 auf das untere Ende $o_{low}$ der vorgegebenen Ausgangsdynamik o, hier den Hörbereich h abgebildet, wie in den Fig. 5a, 6a gezeigt. Ein Kammfiltereffekt entsteht somit speziell dann, wenn der Direktschallpegel $n_{low}$ wie in den Fig. 5a, 6a gezeigt dem unteren Ende $o_{low}$ der Ausgangsdynamik o ähnlich ist. Durch einen entsprechenden Mindestabstand x zwischen dem unteren Ende $o_{low}$ der Ausgangsdynamik o und dem Direktschallpegel $n_{low}$, wie in den Fig. 5b und 6b gezeigt, wird das Risiko von Kammfiltereffekten reduziert.

In den hier gezeigten Ausführungsbeispielen ist der Direktschallpegel $n_{low}$ ein Pegel eines stationären Störgeräuschs der akustischen Szene S und entspricht dem unteren Ende $d_{low}$ des Dynamikbereichs d der Szene S. Die Ausführungen, gelten aber analog auch für andere Direktschallsignale und auch analog für das obere Ende $o_{high}$ der Ausgangsdynamik o, welches gegebenenfalls analog verschoben wird, um einen Mindestabstand x zum Direktschallpegel (dann $n_{high}$, nicht in den Figuren gezeigt) einzuhalten und dadurch Kammfiltereffekte zu vermeiden.

Der Mindestabstand x beträgt vorliegend 6 dB. In welcher Richtung der Mindestabstand x eingehalten wird, ist von untergeordneter Bedeutung, in den Fig. 5b, 6b sind beide Varianten gezeigt. Tatsächlich kann das untere Ende $o_{low}$ so verschoben werden, dass der Direktschallpegel $n_{low}$ entweder innerhalb (Fig. 6b) oder außerhalb (Fig. 5b) der Ausgangsdynamik o liegt, wichtig ist nur, dass der Mindestabstand x eingehalten wird. Vorliegend wird das untere Ende $o_{low}$ der Ausgangsdynamik o in diejenige Richtung verschoben, in welcher die geringere Änderung erforderlich ist. So beträgt in Fig. 5b der Direktschallpegel $n_{low}$ 59 dB und das untere Ende $o_{low}$ der Ausgangsdynamik o 60 dB, dann wird das untere Ende $o_{low}$ um 5 dB nach oben verschoben, d.h. auf 65 dB. Beträgt hingegen der Direktschallpegel $n_{low}$ wie in Fig. 6b gezeigt 46 dB und das untere Ende $o_{low}$ der Ausgangsdynamik o 45 dB, dann wird umgekehrt das untere Ende $o_{low}$ um 5 dB nach unten verschoben, d.h. auf 40 dB. Die jeweilige Verschiebung wird hier durch eine Verschiebung des ersten Kniepunkts 18 erzielt. Dadurch ergibt sich auch eine andere Steigung auf dem ersten Abschnitt 22. Grundsätzlich sind aber auch andere Anpassungen der AGC-Funktion 14 denkbar, um das untere Ende $o_{low}$ entsprechend zu verschieben und den Mindestabstand x herzustellen. In den Fig. 5a bis 6b ist die lediglich exakt auf den Hörbereich h entsprechende Ausgangsdynamik o mit o1 bezeichnet und die zur Reduzierung von Kammfiltereffekten verschobene Ausgangsdynamik o mit o2.

Grundsätzlich kann der Direktschallpegel $n_{low}$ auf verschiedene Weisen ermittelt werden. Vorliegend wird der Direktschallpegel $nl_{ow}$ einfach ermittelt, indem das untere Ende $d_{low}$ des Dynamikbereichs d gemessen wird und als Direktschallpegel $n_{low}$ verwendet wird. Dies ist möglich, da der Direktschallpegel $n_{low}$ ein Pegel eines stationären Störgeräuschs der akustischen Szene S ist.

Die in den Fig. 5b, 6b gezeigte zusätzliche Anpassung zur Vermeidung von Kammfiltereffekten erfolgt am unteren Ende $d_{low}$ der Szenendynamik, d.h. am Störgeräuschende der akustischen Szene S, während das obere Ende $d_{high}$, welches besonders relevant für die Sprachausgabe ist, unbeeinflusst von jeglicher Korrektur zur Vermeidung von Kammfiltereffekten bleibt. Damit werden Kammfiltereffekte reduziert und zugleich bleiben Sprachverständlichkeit und Geräuschqualität maximal erhalten.

Vorliegend wird das obige Konzept umgesetzt, indem zunächst geprüft wird, ob der absolute Unterschied zwischen unterem Ende $o_{low}$ der Ausgangsdynamik o und Direktschallpegel $n_{low}$ weniger als dem Mindestabstand x entspricht, d.h. ob erfüllt ist:

$$|o_{low} - n_{low}| < 6\ dB?$$

Dabei wird $n_{low} = dl_{ow}$ angenommen, d.h. der Direktschallpegel $n_{low}$ wird als stationäres Hintergrundgeräusch am unteren Ende $d_{low}$ der Szenendynamik angenommen. Falls nun zusätzlich vorliegt, dass

$$n_{low} \geq o_{low},$$

wie in Fig. 6a gezeigt, dann wird

$$o_{low} = n_{low} - 6\ dB$$

gesetzt, wie in Fig. 6b gezeigt. Falls umgekehrt zusätzlich vorliegt, dass

$$n_{low} < o_{low},$$

wie in Fig. 5a gezeigt, dann wird

$$o_{low} = n_{low} + 6\ dB$$

gesetzt, wie in Fig. 5b gezeigt.

**In** einer nicht explizit gezeigten Ausgestaltung werden die Parameter frequenzabhängig eingestellt. Mit anderen Worten: das AGC-Eingangssignal $E_{AGC}$ oder bereits das Eingangssignal E wird auf mehrere Frequenzbereiche aufgeteilt, z.B. mittels einer Filterbank, welche z.B. ein Teil der Signalverarbeitung 8 ist. Die Parameter werden dann für jeden der Frequenzbereiche separat eingestellt, sodass für jeden einzelnen Frequenzbereich eine eigene AGC-Funktion 14 verwendet wird.

Ebenfalls optional ist bei der Einstellung der Parameter auch eine Berücksichtigung der Höranstrengung (äquivalent: Erschöpfung) des Nutzers. **In** einer geeigneten Ausgestaltung wird entsprechend eine Höranstrengung des Nutzers ermittelt und einer oder mehrere der Parameter werden zusätzlich (zusätzlich zur Szenenabhängigkeit) abhängig von der Höranstrengung eingestellt.

Bezugszeichenliste

| | |
|---|---|
| 2 | Hörgerät |
| 4 | Eingangswandler |
| 6 | Ausgangswandler |
| 8 | Signalverarbeitung |
| 10 | Verstärkungseinheit |
| 12 | AGC-Einheit |
| 14 | AGC-Funktion |
| 16 | Szenenerkennungseinheit |
| 18 | erster Kniepunkt |
| 20 | zweiter Kniepunkt |
| 22 | erster Abschnitt |
| 24 | zweiter Abschnitt |
| 26 | dritter Abschnitt |
| 28 | Sprachaktivität-Erkennungseinheit |
| A | Ausgangssignal |
| $A_{AGC}$ | AGC- Ausgangssignal |
| d | Dynamikbereich einer Szene, Szenendynamik |
| $d_{low}$ | unteres Ende des Dynamikbereichs einer Szene |
| $d_{high}$ | oberes Ende des Dynamikbereichs einer Szene |
| $d_{max}$ | maximaler Szenenpegel |
| E | Eingangssignal |
| $E_{AGC}$ | AGC- Eingangssignal |
| $g_{shift}$ | Offset |
| h | Hörbereich |
| $h_{low}$ | unteres Ende des Hörbereichs |
| $h_{high}$ | oberes Ende des Hörbereichs |
| $h_{max}$ | maximaler Hörpegel |
| m1 | Maximalwert (für den Offset) |
| $n_{low}$ | Direktschallpegel |
| o, o1, o2 | Ausgangsdynamik (z.B. Dynamik des Ausgangssignals oder des AGC-Ausgangssignals) |
| $o_{low}$ | unteres Ende der Ausgangsdynamik |
| $o_{high}$ | oberes Ende der Ausgangsdynamik |
| $p_A$ | Pegel des Ausgangssignals/AGC-Ausgangssignals |
| $p_E$ | Pegel des Eingangssignals/AGC-Eingangssignals |
| S | Szene |
| S1 - S4 | Schritt |
| $S_{hearing}$ | erste Steigung |
| $s_{loud}$ | zweite Steigung |
| U | Audiosignal |
| x | Mindestabstand |

**Patentansprüche**

1. Verfahren zum Betrieb eines Hörgeräts (2), welches einem Nutzer zugeordnet ist,

   a. wobei das Hörgerät (2) ein Audiosignal (U) aufnimmt und daraus ein Eingangssignal (E) erzeugt,
   b. wobei aus dem Eingangssignal (E) ein AGC-Eingangssignal ($E_{AGC}$) erzeugt wird, welches einer AGC-Einheit (12) des Hörgeräts (2) zugeführt wird,
   c. wobei die AGC-Einheit (12) das AGC-Eingangssignal ($E_{AGC}$) abhängig von einem Pegel des AGC-Eingangssignals ($E_{AGC}$) und gemäß einer AGC-Funktion (14) verstärkt und dann als ein AGC-Ausgangssignal ($A_{AGC}$) ausgibt,
   d. wobei die AGC-Funktion (14) durch einen oder mehrere Parameter (18, 20, $g_{shift}$, $S_{hearing}$, $s_{loud}$) definiert ist, welche abhängig von einer akustischen Szene (S) eingestellt werden, welche aktuell vorliegt,
   e. wobei das Hörgerät (2) aus dem AGC-Ausgangssignal ($A_{AGC}$) ein Ausgangssignal (A) erzeugt, zur Ausgabe an den Nutzer,

f. wobei eine Ausgangsdynamik (o) vorgegeben ist, mit einem unteren Ende ($o_{low}$) und einem oberen Ende ($o_{high}$),

g. wobei ein Dynamikbereich (d) der akustischen Szene (S) ermittelt wird, z.B. aus dem Eingangssignal (E) oder aus dem AGC-Eingangssignals ($E_{AGC}$) abgeleitet wird, mit einem unteren Ende ($d_{low}$) und einem oberen Ende ($d_{high}$),

h. wobei die Parameter (18, 20, $g_{shift}$, $S_{hearing}$, $s_{loud}$) derart eingestellt werden, dass die AGC-Funktion (14) den Dynamikbereich (D) auf die Ausgangsdynamik (o) abbildet,

i. wobei die Ausgangsdynamik (o) einem Hörbereich (h) des Nutzers entspricht,

**dadurch gekennzeichnet,**

j. **dass** ein Direktschallpegel der akustischen Szene (S) ermittelt wird,

k. **dass** der eine oder die mehreren Parameter (18, 20, $g_{shift}$, $S_{hearing}$, $s_{loud}$) derart eingestellt wird, dass das untere Ende ($o_{low}$) oder das obere Ende ($o_{high}$) der Ausgangsdynamik (o) einen vorgegebenen Mindestabstand zu dem Direktschallpegel aufweist.

2. Verfahren nach Anspruch 1,

   wobei der Hörbereich (h) ein komfortabler Hörbereich des Nutzers ist,
   wobei der Dynamikbereich (d) ein relevanter Dynamikbereich ist.

3. Verfahren nach einem der Ansprüche 1 bis 2,

   wobei einer der Parameter ein erster Kniepunkt (18) ist, welcher derart eingestellt wird, dass dieser an den unteren Enden ($d_{low}$, $o_{low}$) des Dynamikbereichs (d) und der Ausgangsdynamik (o) liegt,
   wobei ein weiterer der Parameter ein zweiter Kniepunkt (20) ist, welcher derart eingestellt wird, dass dieser an den oberen Enden ($d_{high}$, $o_{high}$) des Dynamikbereichs (d) und der Ausgangsdynamik (o) liegt.

4. Verfahren nach einem der Ansprüche 1 bis 3,

   wobei einer der Parameter ein Offset ($g_{shift}$) ist, wobei der Offset ($g_{shift}$) eingestellt wird auf einen Wert, welcher einer Differenz aus den unteren Enden ($d_{low}$, $o_{low}$) der Ausgangsdynamik (o) und des Dynamikbereichs (d) entspricht.

5. Verfahren nach Anspruch 4,
   wobei das untere Ende ($o_{low}$) der Ausgangsdynamik derart bestimmt wird, dass die Differenz zum unteren Ende ($d_{low}$) des Dynamikbereichs (d) einen Maximalwert (m1) nicht überschreitet.

6. Verfahren nach einem der Ansprüche 1 bis 5, wobei einer der Parameter eine erste Steigung ($s_{hearing}$) ist, welche derart eingestellt wird, dass diese dem Verhältnis von einer Differenz von oberem und unterem Ende ($h_{low}$, $h_{high}$) der Ausgangsdynamik (o) zu einer Differenz von oberem und unterem Ende ($d_{low}$, $d_{high}$) des Dynamikbereichs (d) entspricht.

7. Verfahren nach Anspruch 6,

   wobei ermittelt wird, ob in dem Eingangssignal (E) Sprache vorhanden ist oder nicht,
   wobei die erste Steigung ($s_{hearing}$) auf einen Wert von 1 begrenzt wird, falls in dem Eingangssignal (E) keine Sprache vorhanden ist.

8. Verfahren nach einem der Ansprüche 1 bis 7, wobei einer der Parameter eine zweite Steigung ($s_{loud}$) ist, welche derart eingestellt wird, dass diese dem Verhältnis von einer Differenz von einem maximalen Hörpegel ($h_{max}$) und dem oberen Ende ($o_{high}$) der Ausgangsdynamik (o) zu einer Differenz von einem maximalen Szenenpegel ($d_{max}$) und dem oberem Ende ($d_{high}$) des Dynamikbereichs (d) entspricht.

9. Verfahren nach einem der Ansprüche 1 bis 8, wobei das untere und das obere Ende ($d_{low}$, $d_{high}$) des Dynamikbereichs (d) als Minimum und Maximum des Eingangssignals (E) innerhalb eines vordefinierten Zeitbereichs ermittelt werden und/oder basierend auf einer statistischen Analyse des Eingangssignals (E).

10. Verfahren nach einem der Ansprüche 1 bis 9, wobei der Direktschallpegel ermittelt wird, indem das untere Ende des Dynamikbereichs gemessen wird und als Direktschallpegel verwendet wird.

11. Verfahren nach einem der Ansprüche 1 bis 10, wobei das Hörgerät (2) ein Gehörgangsmikrofon aufweist, mit welchem der Direktschallpegel gemessen wird.

12. Verfahren nach einem der Ansprüche 1 bis 11, wobei die Parameter frequenzabhängig eingestellt werden.

13. Verfahren nach einem der Ansprüche 1 bis 12,

    wobei eine Höranstrengung des Nutzers ermittelt wird,
    wobei einer oder mehrere der Parameter zusätzlich abhängig von der Höranstrengung eingestellt werden.

14. Hörgerät (2), welches ausgebildet ist zur Durchführung eines Verfahrens gemäß einem der Ansprüche 1 bis 13.

**Claims**

1. Method for operating a hearing aid (2) that is assigned to a user,

   a. wherein the hearing aid (2) records an audio signal (U) and generates an input signal (E) therefrom,
   b. wherein an AGC input signal ($E_{AGC}$) is generated from the input signal (E) and is supplied to an AGC unit (12) of the hearing aid (2),
   c. wherein the AGC unit (12) amplifies the AGC input signal ($E_{AGC}$) depending on a level of the AGC input signal ($E_{AGC}$) and in accordance with an AGC function (14) and then outputs it as an AGC output signal ($A_{AGC}$),
   d. wherein the AGC function (14) is defined by one or more parameters (18, 20, $g_{shift}$, $S_{hearing}$, $s_{loud}$) that are set depending on an acoustic scene (S) that is currently present,
   e. wherein the hearing aid (2) generates an output signal (A) to be output to the user from the AGC output signal ($A_{AGC}$),
   f. wherein an output dynamic range (o) is specified, having a lower end ($o_{low}$) and an upper end ($o_{high}$),
   g. wherein a dynamic range (d) of the acoustic scene (S) is ascertained, e.g. is derived from the input signal (E) or from the AGC input signal ($E_{AGC}$), having a lower end ($d_{low}$) and an upper end ($d_{high}$),
   h. wherein the parameters (18, 20, $g_{shift}$, $S_{hearing}$, $s_{loud}$) are set such that the AGC function (14) maps the dynamic range (d) onto the output dynamic range (o),
   i. wherein the output dynamic range (o) corresponds to a hearing range (h) of the user, **characterized**
   j. **in that** a direct sound level of the acoustic scene (S) is ascertained,
   k. **in that** the one or more parameters (18, 20, $g_{shift}$, shearing, $s_{loud}$) are set such that the lower end ($o_{low}$) or the upper end ($o_{high}$) of the output dynamic range (o) is at a predefined minimum distance from the direct sound level.

2. Method according to Claim **1,**

   wherein the hearing range (h) is a comfortable hearing range of the user,
   wherein the dynamic range (d) is a relevant dynamic range.

3. Method according to one of Claims 1 to **2,**

   wherein one of the parameters is a first knee point (18) that is set such that it lies at the lower ends ($d_{low}$, $o_{low}$) of the dynamic range (d) and of the output dynamic range (o),
   wherein another one of the parameters is a second knee point (20) that is set such that it lies at the upper ends ($d_{high}$, $o_{high}$) of the dynamic range (d) and of the output dynamic range (o).

4. Method according to one of Claims 1 to **3,**

   wherein one of the parameters is an offset ($g_{shift}$),
   wherein the offset ($g_{shift}$) is set to a value that corresponds to a difference between the lower ends ($d_{low}$, $o_{low}$) of the output dynamic range (o) and of the dynamic range (d).

5. Method according to Claim 4, wherein the lower end ($o_{low}$) of the output dynamic range is determined such that the difference from the lower end ($d_{low}$) of the dynamic range (d) does not exceed a maximum value (m1).

6. Method according to one of Claims 1 to 5, wherein one of the parameters is a first gradient ($s_{hearing}$) that is set such that it corresponds to the ratio of a difference between the upper and lower end ($h_{low}$, $h_{high}$) of the output dynamic range (o) to a difference between the upper and lower end ($d_{low}$, $d_{high}$) of the dynamic range (d).

7. Method according to Claim 6,

   wherein it is ascertained whether or not voice is present in the input signal (E),
   wherein the first gradient ($s_{hearing}$) is limited to a value of 1 if no voice is present in the input signal (E).

8. Method according to one of Claims 1 to 7, wherein one of the parameters is a second gradient ($s_{loud}$) that is set such that it corresponds to the ratio of a difference between a maximum hearing level ($h_{max}$) and the upper end ($o_{high}$) of the output dynamic range (o) to a difference between a maximum scene level ($d_{max}$) and the upper end ($d_{high}$) of the dynamic range (d).

9. Method according to one of Claims 1 to 8, wherein the lower and upper end ($d_{low}$, $d_{high}$) of the dynamic range (d) are ascertained as a minimum and maximum of the input signal (E) within a predefined time range and/or based on a statistical analysis of the input signal (E).

**10.** Method according to one of Claims 1 to 9, wherein the direct sound level is ascertained by measuring the lower end of the dynamic range and using it as a direct sound level.

**11.** Method according to one of Claims 1 to 10, wherein the hearing aid (2) has an ear canal microphone that is used to measure the direct sound level.

**12.** Method according to one of Claims 1 to 11, wherein the parameters are set on a frequency-dependent basis.

**13.** Method according to one of Claims 1 to 12,

wherein a hearing effort of the user is ascertained,

wherein one or more of the parameters are additionally set depending on the hearing effort.

**14.** Hearing aid (2) designed to perform a method according to one of Claims 1 to 13.

**Revendications**

**1.** Procédé de fonctionnement d'une prothèse auditive (2) qui est attribuée à un utilisateur,

a. dans lequel la prothèse auditive (2) reçoit un signal audio (U) et génère un signal d'entrée (E) à partir de celui-ci,

b. dans lequel un signal d'entrée AGC ($E_{AGC}$) est généré à partir du signal d'entrée (E) et est délivré à une unité AGC (12) de la prothèse auditive (2),

c. dans lequel l'unité AGC (12) amplifie le signal d'entrée AGC ($F_{AGC}$) en fonction d'un niveau du signal d'entrée AGC ($E_{AGC}$) et conformément à une fonction AGC (14) puis le délivre en tant que signal de sortie AGC ($A_{AGC}$),

d. dans lequel la fonction AGC (14) est définie par un ou plusieurs paramètres (18, 20, $g_{shift}$, $S_{hearing}$, $s_{loud}$) qui sont réglés en fonction d'une scène acoustique (S) qui est actuellement présente,

e. dans lequel la prothèse auditive (2) génère un signal de sortie (A) à partir du signal de sortie AGC ($A_{AGC}$) pour le délivrer à l'utilisateur,

f. dans lequel une dynamique de sortie (o) est prédéfinie avec une extrémité inférieure ($o_{low}$) et une extrémité supérieure ($o_{high}$),

g. dans lequel une gamme dynamique (d) de la scène acoustique (S) est déterminée, par exemple dérivée du signal d'entrée (E) ou du signal d'entrée AGC ($E_{AGC}$), avec une extrémité inférieure ($d_{low}$) et une extrémité supérieure ($d_{high}$),

h. dans lequel les paramètres (18, 20, $g_{shift}$, $S_{hearing}$, $s_{loud}$) sont réglés de telle sorte que la fonction AGC (14) projette la gamme dynamique (D) sur la dynamique de sortie (o),

i. dans lequel la dynamique de sortie (o) correspond à une gamme auditive (h) de l'utilisateur, **caractérisé**

j. **en ce qu'**un niveau sonore direct de la scène acoustique (S) est déterminé,

k. **en ce que** le ou les multiples paramètres (18, 20, $g_{shift}$, $S_{hearing}$, $s_{loud}$) sont réglés de telle sorte que l'extrémité inférieure ($o_{low}$) ou l'extrémité supérieure ($o_{high}$) de la dynamique de sortie (o) présente une distance minimale prédéfinie par rapport au niveau sonore direct.

**2.** Procédé selon la revendication 1, dans lequel la gamme auditive (h) est une gamme auditive confortable de l'utilisateur, la gamme dynamique (d) étant une gamme dynamique pertinente.

**3.** Procédé selon l'une des revendications 1 à 2,

dans lequel l'un des paramètres est un premier point de coude (18) qui est réglé de telle sorte qu'il se situe aux extrémités inférieures ($d_{low}$, $o_{low}$) de la gamme dynamique (d) et de la dynamique de sortie (o),

un autre des paramètres étant un deuxième point de coude (20) qui est réglé de telle sorte qu'il se situe aux extrémités supérieures ($d_{high}$, $o_{high}$) de la gamme dynamique (d) et de la dynamique de sortie (o).

**4.** Procédé selon l'une des revendications 1 à 3, dans lequel l'un des paramètres est un décalage ($g_{shift}$), le décalage ($g_{shift}$) étant réglé à une valeur qui correspond à une différence entre les extrémités inférieures ($d_{low}$, $o_{low}$) de la dynamique de sortie (o) et de la gamme dynamique (d).

**5.** Procédé selon la revendication 4, dans lequel l'extrémité inférieure ($o_{low}$) de la dynamique de sortie est déterminée de telle sorte que la différence par rapport à l'extrémité inférieure ($d_{low}$) de la gamme dynamique (d) ne dépasse pas une valeur maximale ($m1$).

**6.** Procédé selon l'une des revendications 1 à 5, dans lequel l'un des paramètres est une première pente ($s_{hearing}$) qui est réglée de telle sorte qu'elle corresponde au rapport d'une différence entre les extrémité supérieure et inférieure ($h_{low}$, $h_{high}$) de la dynamique de sortie (o) à une différence entre les extrémités supérieure et inférieure ($d_{low}$, $d_{high}$) de la gamme dynamique (d).

**7.** Procédé selon la revendication 6,

dans lequel il est déterminé si de la parole est présente ou non dans le signal d'entrée (E), la première pente ($s_{hearing}$) étant limitée à une valeur de 1 si aucune parole n'est présente dans le signal d'entrée (E).

8. Procédé selon l'une des revendications 1 à 7, dans lequel l'un des paramètres est une deuxième pente ($s_{loud}$) qui est réglée de telle sorte qu'elle corresponde au rapport d'une différence entre un niveau d'audition maximal ($h_{max}$) et l'extrémité supérieure ($o_{high}$) de la dynamique de sortie (o) à une différence entre un niveau de scène maximal ($d_{max}$) et l'extrémité supérieure ($d_{high}$) de la gamme dynamique (d).

9. Procédé selon l'une des revendications 1 à 8, dans lequel les extrémités inférieure et supérieure ($d_{low}$, $d_{high}$) de la gamme dynamique (d) sont déterminées comme étant le minimum et le maximum du signal d'entrée (E) à l'intérieur d'une plage temporelle prédéfinie et/ou sur la base d'une analyse statistique du signal d'entrée (E).

10. Procédé selon l'une des revendications 1 à 9, dans lequel le niveau sonore direct est déterminé en mesurant l'extrémité inférieure de la gamme dynamique et en l'utilisant en tant que niveau sonore direct.

11. Procédé selon l'une des revendications 1 à 10, dans lequel la prothèse auditive (2) comporte un microphone de conduit auditif au moyen duquel le niveau sonore direct est mesuré.

12. Procédé selon l'une des revendications 1 à 11, dans lequel les paramètres sont réglés en fonction de la fréquence.

13. Procédé selon l'une des revendications 1 à 12,

   dans lequel un effort d'écoute de l'utilisateur est déterminé,
   un ou plusieurs des paramètres étant en outre réglés en fonction de l'effort d'écoute.

14. Prothèse auditive (2) qui est conçue pour mettre en œuvre un procédé selon l'une des revendications 1 à 13.

S1 — [ ]

S3 — [ ]

S2 — [ ]

S4 — [ ]

**Fig. 1**

**Fig. 2**

Fig. 3

Fig. 4

Fig. 5a

Fig. 5b

Fig. 6a

Fig. 6b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005061000 A1
- WO 2021089108 A1
- WO 2022128082 A1
- DE 102007035174 B4
- DE 102018207343 A1
- US 7773763 B2

**In der Beschreibung aufgeführte Nicht-Patentliteratur**

- **DILLON HARVEY**. Hearing Aids Second Edition